# EUROPEAN PATENT SPECIFICATION

(11) **EP 0 308 201 B1**
(45) Date of publication and mention of the grant of the patent: **18.11.1993**
(21) Application number: 88308503.7
(22) Date of filing: 14.09.1988
(51) Int. Cl.: C23C 14/34, G11B 7/24, C22C 33/00, C22C 38/00

(54) **Method of forming a sputtering target for use in producing a magneto-optic recording medium**
Verfahren zum Herstellen eines Zerstäubungstargets zur Verwendung bei der Herstellung eines magnetooptischen Aufzeichnungsmediums
Procédé de fabrication d'une matière-cible pour l'emploi dans la production d'un milieu d'enregistrement magnéto-optique

(30) Priority: 17.09.1987 JP 232772/87; 07.10.1987 JP 253001/87; 14.12.1987 JP 315613/87; 14.12.1987 JP 315614/87; 06.04.1988 JP 84312/88; 13.04.1988 JP 91001/88; 27.05.1988 JP 130539/87
(43) Date of publication of application: 22.03.1989
(73) Proprietor: SEIKO EPSON CORPORATION, Shinjuku-ku Tokyo-to (JP)
(72) Inventor: Aoyama, Akira, Suwa-shi Nagano-ken (JP); Shimokawato, Satoshi, Suwa-shi Nagano-ken (JP); Yamagishi, Toshihiko, Suwa-shi Nagano-ken (JP)
(74) Representative: Miller, Joseph

(56) References cited:
- JP-A- 6 270 550
- JP-A-62 056 543
- JP-A-62 070 550
- JP-A-62 130 236
- JP-A-62 130 236
- JP-A-63 171 877

## Description

The present invention relates to a sputtering target for use in producing a magneto-optic recording medium of a rare earth-transition metal alloy by sputtering.

Such sputtering targets have hitherto been manufactured by a casting method, a sintering method and a semi-melting method. The casting method has involved casting an ingot and machining the outer periphery of the cast ingot to obtain a target. The sintering method has involved casting an ingot, crushing the cast ingot, and sintering the crushed pieces into the form of a target. The semi-melting method is that described in Japanese Patent Laid-Open Specifications Nos. 95788/1986 and 99640/1986.

The sintering method, however, intrinsically produces a target containing a large amount of oxygen (2,000)ppm at the minimum) and is not suitable for rare earth-transition metals which are easily oxidized. On the other hand, the known casting method has had the problem of a non-uniform chemical composition distribution in the film-forming plane in spite of the advantage of a small amount (about 500 ppm) of oxygen.

A target manufactured by the semi-melting method is advantageous in that a non-uniform chemical composition distribution is unlikely to be produced in the substrate plane, but since the semi-melting method fundamentally adopts a sintering method, the target has not been in a completely dense state and pores in the target communicate with the interior of the target. Therefore, when the target is left to stand in the air, oxidization progresses from the surface of the target toward the interior to such an extent that the oxidization layer cannot be cleaned by pre-sputtering.

In JP-A-62130236 there is referred to a method known from JP-A-59219227 of forming a sputtering target of a rare earth-transition metal alloy, whereby a sputtering target having a phase of rare earth metal in single (elemental) form, a phase of iron group metal in simple (elemental) form, and an alloy phase of rare earth metal and iron group metal (intermetallic compound) is formed. JP-A-62130236 also discloses a target comprising one or more rare earth metals and one or more iron group metals.

According to one aspect of the present invention there is provided a method of forming a sputtering target for use in producing a magneto-optic recording medium of a rare earth-transition metal alloy by sputtering, the method including the step of charging a powdered transition metal or a powdered alloy of a plurality of transition metals into a container, the method being characterised by charging in addition a master alloy of one or more rare earth metals and of one or more transition metals into the container; heating the container to a temperature between the melting point of the transition metal or transition metal alloy and the melting point of the master alloy; and cooling the resulting material and forming it into the sputtering target.

According to another aspect of the present invention, there is provided a method of forming a sputtering target for use in producing a magneto-optic recording medium of a rare earth-transition metal alloy by sputtering, the method including the step of charging a foamed transition metal or a foamed alloy of a plurality of transition metals into a container, the method being characterised by charging in addition a master alloy of one or more rare earth metals and of one or more transition metals into the container; heating the container to a temperature between the melting point of the transition metal or transition metal alloy and the melting point of the master alloy; and cooling the resulting material and forming it into the sputtering target.

The master alloy may be formed by melting together at least one rare earth metal and at least one transition metal in the container.

Alternatively, the master alloy may be charged into the container in powder form.

In another embodiment, the master alloy is charged into the container in ingot form.

If the transition metal or transition metal alloy is charged into the container in powder form, the powder of the transition metal or transition metal alloy may have a porosity of between 30% and 80%. In this case too, the powder of the transition metal or transition metal alloy may have an average particle diameter of between 10 microns and 3.0mm.

However, if the transition metal or transition metal alloy is charged into the container in the form of foam, the foam transition metal or foam transition metal alloy may have a porosity of between 30% and 80%. Moreover, the foam transition metal or foamed transition metal alloy may have an average pore diameter of between 10 microns and 3.0mm.

The container may be charged in addition with at least one rare earth metal and at least one transition metal in powdered form.

The container may be a crucible, the cooled material therein being molten and being cast into a mould, and the moulded product being machined to form the target.

The material in the mould may be subjected to heat treatment.

The melting point of the master alloy preferably does not exceed 1200°C.

The constituents of the target may include at least one light rare earth metal selected from the group comprising Sm Nd, Pr and Ce.

Moreover, the constituents of the target may include at least one heavy rare earth metal selected from the group comprising Gd, Tb and Dy.

The constituents of the target may further include at least one transition metal selected from the group comprising Fe and Co.

In a composite target system conventionally adopted in the laboratory, in which a film is formed by disposing a chip of a rare earth metal (hereinunder referred to as "RE") on a target of a transition metal (TM), the chemical composition distribution in the substrate plane exhibits a tendency opposite to that of a cast alloy target.

More specifically, in the case of the composite target, the closer the film is to a position right over the target, the greater is the RE, and the closer the film is to a position beside the target, the greater is the TM. On the other hand, in the case of the cast alloy target, the closer the film is to a position right over the target, the greater is the TM, and the closer the film is to a position beside the target, the greater is the RE. In other words, there is a compensatory relationship between the scattering tendency of the sputtered RE and TM particles in the case of using the cast alloy target and that in the case of using the composite target. It is therefore possible to form a film of a uniform chemical composition distribution in the substrate plane if a target consisting of an appropriate mixture of an RE single phase, a TM single phase and an RE-TM alloy phase is obtained.

The following two methods will be considered as a method of manufacturing a target having a packing density of 100% and which can be oxidized only with difficulty.

One is a method of inserting RE particles and TM particles into a bath of an RE-TM alloy having a low melting point and mixing them. The other is a method of dispersing a TM powder (or sheet) in a bath of an RE-TM alloy which produces the RE phase at the time of solidification. In both methods, since the molten metal of the RE-TM alloy completely surrounds the powder or the sheet, the moulded product obtained is free from minute pores which are inevitable in a sintered product. A pore which may exist in a target of the present invention is like a cavity in a cast product, which does not communicate with the interior, thereby involving no possibility of the surface oxidization progressing to the interior.

The invention is illustrated, merely by way of example, in the accompanying drawings, in which:-
Figure 1 is a schematic view of the surface structure of a sputtering target according to the present invention;
Figure 2 is a schematic view of a sputtering device in which the target of the present invention may be used;
Figure 3 shows the composition distribution and the magnetic characteristic distribution of a film produced on a substrate holder by the use of an NdDyFeCo target according to the present invention;
Figure 4 is a schematic view of the surface structure of a known cast alloy target of NdDyFeCo;
Figure 5 shows the chemical composition distribution and the magnetic characteristic distribution of a film produced on a substrate holder by the use of the target of NdDyFeCo shown in Figure 4;
Figure 6 shows the chemical composition distribution and the magnetic characteristic distribution of a film produced on a substrate holder by the use of a known NdDyFeCo target obtained by a semi-melting method;
Figure 7 shows the relationship between the sputtering time and the magnetic characteristic of the film in the case of using an NdDyFeCo target according to the present invention after standing in the air for 24 hours and that in the case of using a known NdDyFeCo target obtained by a semi-melting method standing in the air for 24 hours;
Figure 8 shows the relationship between the dependence of the magnetic characteristic of the film of an NdDyFeCo target obtained by a semi-melting method on the sputtering time and the time during which the target is left to stand in the air;
Figure 9 shows the composition distribution and the magnetic characteristic distribution of a film on a substrate holder in the case of using a TbFeCo target according to the present invention;
Figure 10 shows the chemical composition distribution and the magnetic characteristic distribution of a film on a substrate holder in the case of using a known cast alloy target of TbFeCo;
Figure 11 shows the chemical composition distribution and the magnetic characteristic distribution on a film on a substrate holder in the case of using a known TbFeCo target obtained by a semi-melting method;
Figure 12 shows the relationship between the sputtering time and the magnetic characteristic of the film in the case of using a TbFeCo target according to the present invention after it has stood in the air for 24 hours and that in the case of using a known TbFeCo target obtained by a semi-melting method after standing in the air for 24 hours;
Figure 13 shows the relationship between the dependence of the magnetic characteristic of the film of a TbFeCo target obtained by a semi-melting method on the sputtering time and on the time the target is left to stand in the air;
Figure 14 is a schematic view of a crucible which may be used in an impregnation method for producing a target according to the present invention;
Figure 15 is a schematic view of the surface structure of a target according to the present invention obtained by an impregnation method;
Figure 16 shows the composition distribution and the magnetic characteristic distribution of a film on a substrate holder in the case of using a target according to the present invention obtained by an impregnation method;
Figure 17 is a schematic view of a metal structure of a target according to the present invention obtained by using a foamed metal sheet;
Figure 18 shows the chemical composition distribution and the magnetic characteristic distribution on a substrate holder in the case of using a target according to the present invention obtained by using a foamed metal sheet;
Figure 19(a) is a schematic view of an ingot of a master alloy before being melted into the pores of a powder having a porosity of about 30%;
Figure 19(b) is a schematic view similar to Figure 19(a) but showing the state after the infiltration of the master alloy;
Figure 20(a) is a schematic view of an ingot of a master alloy before being melted into the pores of a powder having a porosity of about 80%;
Figure 20(b) is a schematic view similar to Figure 20(a) but showing the state after the infiltration of the master alloy;
Figure 21 shows the chemical composition distributions on a substrate holder in the case of the use of NdDyFeCo targets obtained from powders having various porosities;
Figure 22 shows the chemical composition distributions on a substrate holder in the case of the use of NdDyFeCo targets obtained from foamed sheets having various porosities;
Figure 23 shows the chemical composition distributions on a substate holder in the case of the use of TbFeCo targets obtained from powders having various porosities;
Figure 24 shows the chemical composition distributions on a substrate holder in the case of the use of TbFeCo targets obtained from foamed sheets having various porosities;
Figure 25 shows the relationship between the magnetic characteristic of a film and the sputtering time in the case of the use of NdDyFeCo targets obtained from powders having particle diameters of 10 to 570 µm;
Figure 26 shows the relationship between the magnetic characteristic of a film and the sputtering time in the case of the use of NdDyFeCo targets obtained from powders having particle diameters of 730 µm to 4.0 mm;
Figure 27 shows the relationship between the magnetic characteristic of a film and the sputtering time in the case of the use of TbFeCo targets obtained from powders having particle diameters of 10 to 570 µm;
Figure 28 shows the relationship between the magnetic characteristic of a film and the sputtering time in the case of the use of TbFeCo targets obtained from powders having particle diameters of 730 µm to 4.0 mm;
Figure 29 shows the relationship between the magnetic characteristic of a film and the sputtering time in the case of the use of NdDyFeCo targets obtained from foamed metal sheets having pore diameters of 10 to 570 µm ;
Figuer 30 shows the relationship between the magnetic characteristic of a film and the sputtering time in the case of the use of NdDyFeCo targets obtained from foamed metal sheets having pore diameters of 730 µm to 4.0 mm;
Figure 31 shows the relationship between the magnetic characteristic of a film and the sputtering time in the case of the use of TbFeCo targets obtained from foamed metal sheets having pore diameters of 10 to 570 µm;
Figure 32 shows the relationship between the magnetic characteristic of a film and the sputtering time in the case of the use of TbFeCo targets obtained from foamed metal sheets having pore diameters of 730 µm to 4.0 mm;
Figure 33 is a schematic view of a sputtering device showing a stationary substrate facing a target;
Figure 34 is a schematic view of a sputtering device in which a substrate passes over a target; and
Figure 35 shows the structure of a magneto-optic recording medium which was produced by a sputtering target according to the present invention.

The invention is illustrated by the following Examples.

### Example 1-1

An ingot of an alloy of 23 at% of Nd and 77 at% of Dy was first prepared as a raw material. The ingot was pulverized into an NdDy powder having an average particle diameter of about 500 µm. Separately from this, an ingot of an alloy of 80.5 at% of Fe and 19.5 at% of Co was prepared. The FeCo ingot was pulverized into an FeCo powder having an average particle diameter of about 200 µm.

Nd, Dy, Fe and Co were charged in powdered or bulk form into a crucible in the atomic ratio of 10.0 : 35.0 : 44.0 : 11.0 and were completely melted by heating them to 1,550°C. Thereafter the temperature was lowered to 1,200°C and the NdDy powder and FeCo powder were added to the molten metal of NdDyFeCo alloy in the crucible. Since the melting point of NdDy was 1,400°C and the melting point of FeCo was 1,530°C, both of them existed in the molten metal of 1,200°C in the form of NdDy powder and FeCo powder, respectively, without dissolving therein. The ratio of NdDyFeCo, NdDy and FeCo contents were as follows:

(NdDyFeCo)_{A} [(NdDy)_{C}(FeCo)_{D}]_{B}

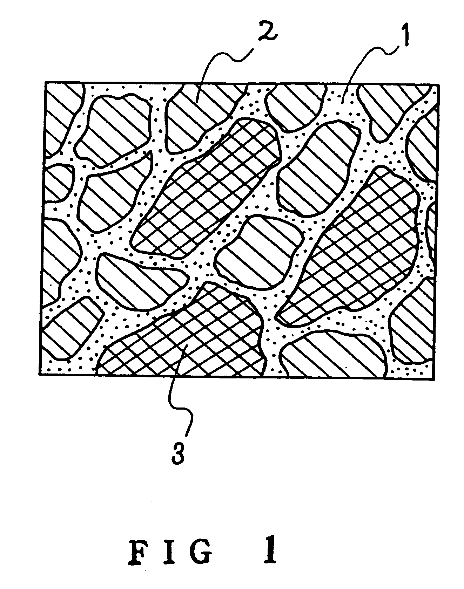

A : B = 25 : 75 wt%
C : D = 28 : 72 at%
The thus-obtained molten (NdDyFeCo)(NdDy) (FeCo) was cast into a mould, and the cast alloy was machined to obtain a sputtering target of 4" φ x 6t. The surface structure of the thus-obtained sputtering target is schematically shown in Figure 1. The reference numeral 1 denotes an alloy phase of 33 at% of (NdDy) and 67 at% of (FeCo), 2 denotes an FeCo phase and 3 denotes an NdDy phase. That is, the surface structure was composed of an RE single phase 3 of NdDy, a TM single phase 2 of FeCo and an RE-TM alloy phase 1 of NdDyFeCo.

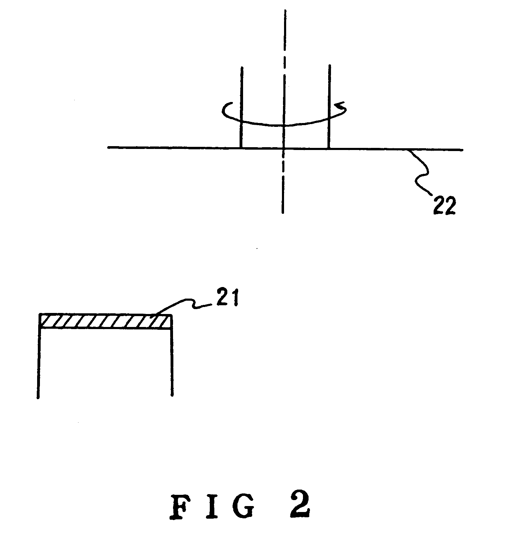

A so-formed NdDyFeCo target 21 was mounted on a sputtering device such as that shown in Figure 2 for film formation and the magnetic characteristic and the chemical composition distribution of the film obtained were examined. In Figure 2 the reference numeral 22 denotes a substrate holder (300 φ). The film forming conditions were that an argon pressure of 2.5m Torr argon was employed, the initial vacuum was 3 x 10⁻⁷ Torr, and the current applied by a DC power source was 1.0 A at 340 V.

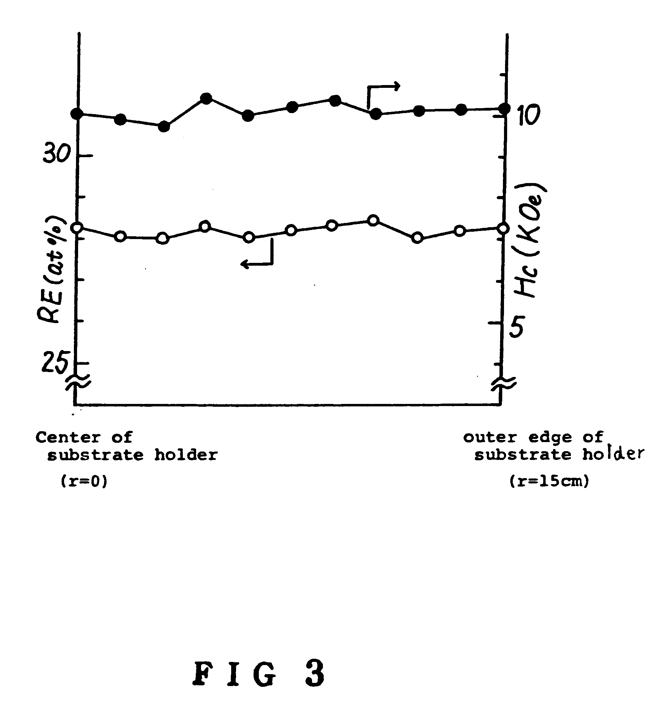

Figure 3 shows the chemical composition distribution and the magnetic characteristic distribution of a film produced on a substrate holder by the use of a target of the present invention. As shown in Figure 3, in the case of the chemical composition, the RE content is uniformly 28.0 and 28.5 at%, and in the case of the magnetic characteristics, the Hc is uniformly 9.7 to 10.5 KOe. Thus a substantially uniform film was formed on the substrate holder. Since this target was made of a cast alloy, the amount of oxygen was naturally as small as 350 ppm.

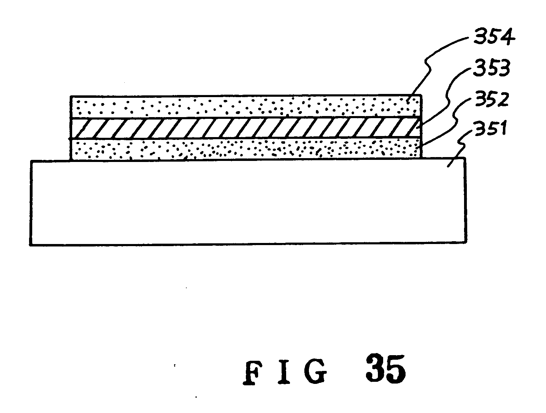

A magneto-optic recording medium was produced by sputtering while using the target of this embodiment. The structure of the medium is shown in Figure 35. In Figure 35, the reference numeral 351 represents a polycarbonate substrate, 352 an Aℓ SiN dielectric film, 353 an NdDyFeCo film formed by using the target of the present invention, and 354 an AℓSiN dielectric film. The C/N ratio of the thus-obtained medium was as high as 59 dB at a linear velocity of 5.7 m/sec and a Domain length of 1.4 µm. In a reliability test of the medium, no pitting corrosion was produced for as long as 3,000 hours at a cosntant temperature of 90°C and at a constant relative humidity of 90%.

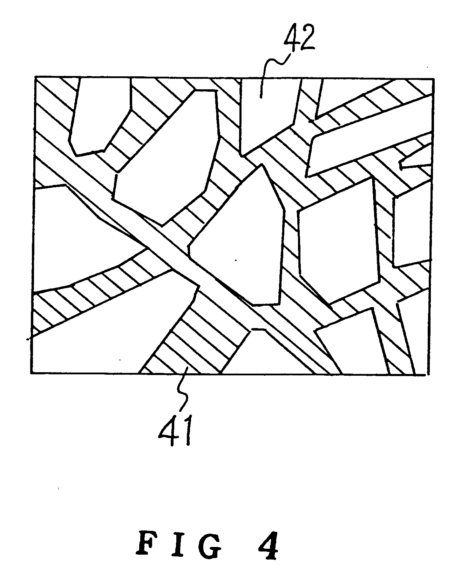

For comparison, an NdDyFeCo target was manufactured by a known method. Aℓl the constituents of an NdDyFeCo alloy were melted in a crucible at 1,500°C, and poured into a mould to produce an ingot. The ingot obtained was cut and ground to produce an NdDyFeCo target of 4" φ x 6t. The surface structure of the thus-obtained target is schematically shown in Figure 4.

In Figure 4, the reference numeral 41 represents a phase of 25 at% of (Nd_{0.12}Dy_{0.88}) and 75 at% of (Fe_{0.8}Co_{0.2}), and 42 a phase of 33.3 at% of (Nd_{0.3}Dy_{0.7}) and 66.7 at% of (Fe_{0.8}Co_{0.2}). That is, both phases are NdDyFeCo alloy phases. In the whole composition of the surface structure, Nd was 6.5 at%, Dy 21.5 at%, Fe 58 at% and Co 14 at%. This target was mounted on the sputtering device shown in Figure 2 for film formation.

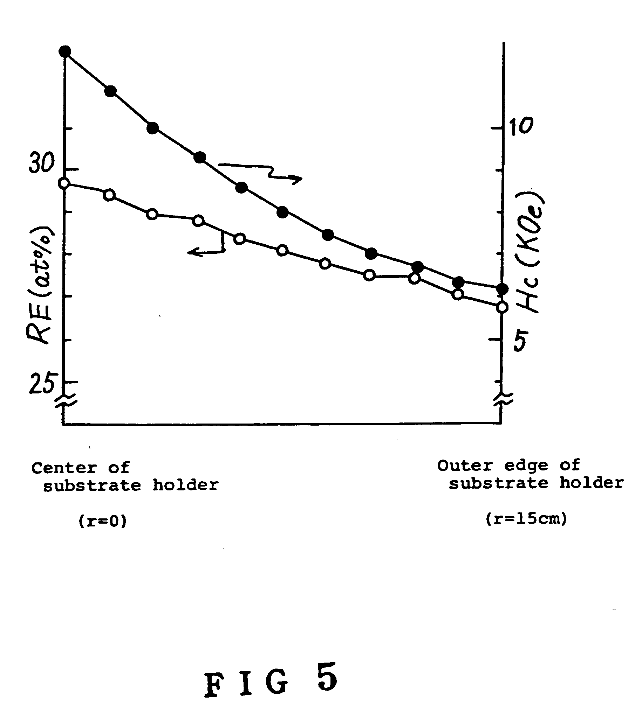

Figure 5 shows the chemical composition distribution and the magnetic characteristic distribution of a film on a substrate holder produced by using the cast NdDyFeCo target shown in Figure 4. As shown in Figure 5, in the case of the chemical composition, the RE content varies from 29.8 to 26.8 at%, and the closer to the centre of the substrate holder, the greater is the RE content, while the closer to the outer periphery of the holder, the smaller is the RE content. In the case of the magnetic characteristics, the Hc varies from 12 to 6 KOe. Namely, the closer to the centre of the holder, the greater is the Hc. This tendency agrees with the chemical composition distribution.

A magneto-optic recording medium was produced by sputtering by the use of the known target. The structure of the medium was the same as that shown in Figure 35, the magneto-optic recording layer being sandwiched between AℓSiN dielectric films. The C/N ratio of the medium was a little low since the film had the characteristic of 55 dB at a linear velocity of 5.7 m/sec and a Domain length of 1.4 µm. This is due to the influence of the chemical composition distribution in the medium. In a reliability test of the medium, no pitting corrosion was produced for up to 3,000 hours at a constant temperature of 90°C and a constant relative humidity of 90%.

For further comparison, an NdDyFeCo alloy target was manufactured by a semi-melting method as described in Japanese Patent Laid-Open Specifications Nos. 95788/1986 and 99640/1986 and the film formed thereby was evaluated. The target composition was 6.5 at% of Nd, 21.5 at% of Dy, 58 at% of Fe and 14 at% of Co. The contents of NdDy, NdDyFeCo and FeCo were the same as above. The amount of oxygen in the target was 1,5000 ppm. The target was mounted on the sputtering device shown in Figure 2, and after the surface of the target was sufficiently cleaned by pre-sputtering, a film was formed. The film forming conditions were the same as above.

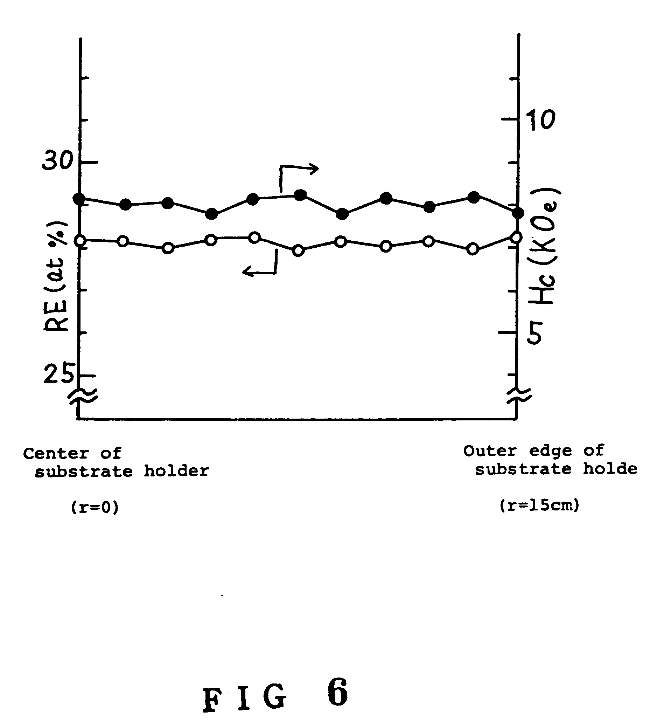

Figure 6 shows the chemical composition distribution and the magnetic characteristic distribution of a film produced on a substrate holder by the use of the NdDyFeCo alloy target obtained by the semi-melting method. The chemical composition distribution is almost the same as that shown in Figure 3 in the case of using the target of the present invention, but the magnetic characteristic distribution moves toward the smaller coercive force (Hc). This phenomenon was caused because the target obtained by the semi-melting method was a sintered body, so that the amount of oxygen was larger than that in the target of the present inventionand the rare earth metals had been partially oxidized.

A magneto-optic recording medium was produced by sputtering by the use of this target obtained by the semi-melting method. The structure of the medium was the same as that shown in Figure 35, the magneto-optic recording layer being sandwiched between AℓSiN dielectric films. The C/N ratio of the medium was a little low since the film had the characteristic of 57 dB at a linear velocity of 5.7 m/sec and a Domain length of 1.4 µm. This was because the oxygen in the target had entered the film. In the reliability test of the medium, a pitting corrosion was produced when 200 hours had passed at a constant temperature of 90°C and a constant relative humidity of 90%, and the error rate began to deteriorate. This was also because the oxygen in the target had entered the film.

The NdDyFeCo target of the present invention and the NdDyFeCo target obtained by the semi-melting method were removed from the sputtering device after the end of sputtering, and both targets were left to stand in the air for 24 hours. Thereafter both targets were mounted again on the sputtering device shown in Figure 2 for film formation. The discharging state at the time of sputtering is shown in Table 1.

**TABLE 1**

| | Target according to the present invention | Target obtained by the semi-melting method |
|---|---|---|
| Beginning of sputtering | DC sputtering; Argon pressure : 2.5 mTorr; stable discharge | RF sputtering; discharged with difficulty at Argon pressure of 10 mTorr |
| 1 hour after sputtering | Same as above | DC sputtering; discharged with difficulty at Argon pressure of 10 mTorr |
| 3 hours after sputtering | Same as above | DC sputtering; discharged at Argon pressure of 2.5 mTorr but unstable discharge |
| 7 hours after sputtering | Same as above | DC sputtering; discharged at Argon pressure of 2.5 mTorr and stable discharge obtained with difficulty. |

As shown in Table 1, while the target of the present invention was capable of stable discharge from the beginning at a constant Argon pressure of 2.5 mTorr, the target obtained by the semi-melting method was not capable of DC sputtering at the beginning of sputtering. This was because the target had been left to stand for long hours in the air, thereby making the surface of the target obtained by the semi-melting method completely insulating. In 1 hour, the target obtained by the semi-melting method permitted DC sputtering but an Argon pressure of 10 mTorr was required. It was not until 7 hours after the beginning of discharge that the target obtained by the semi-melting method permitted DC sputtering at an Argon pressure of 2.5 mTorr.

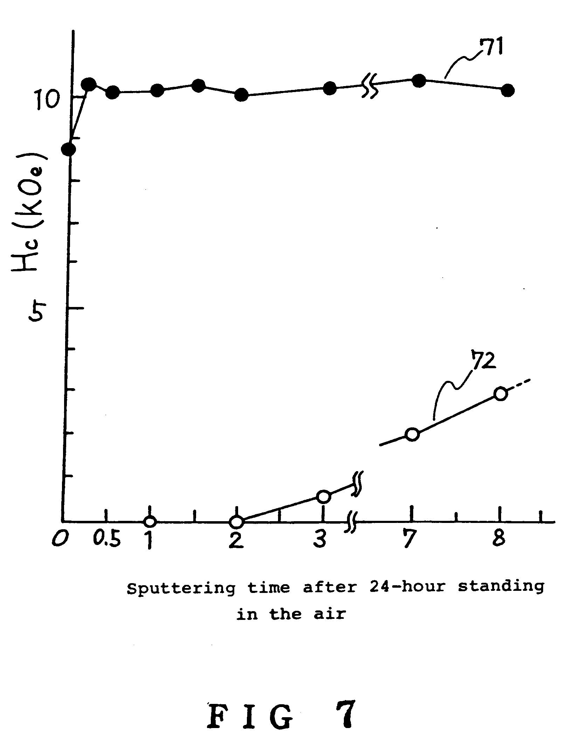

The relationships between the sputtering time and the magnetic characteristic of the film in the case of using these targets after they have stood in the air are shown in Figure 7. The reference numeral 71 denotes the target of the present invention and 72 the target obtained by the semi-melting method. As is clear from Figure 7, the target of the present invention, which had been exposed to the air for a long time, exhibited a stable film characteristic substantially immediately after sputtering. On the other hand, if the target obtained by a semi-melting method had been exposed to the air for a long time, the initial sputtering itself became very difficult, and the film characteristic did not become stable at all even after a long period of pre-sputtering. When the film characteristic became stable, the target had almost been consumed. Since the magnetic characteristic of the film is that of a composition on the TM-rich side of a compensation composition, the larger the coercive force (Hc), the better. That is to say, the alloy phase of the rare earth metal phase and the transition metal phase has a composition such that the magnetic moment of the rare earth metal and the magnetic moment of the transition metal compensate for each other. This composition is referred to as a compensation composition. When this compensation composition is taken as a boundary, a composition having a primarily rare earth metal moment is referred to as a RE (Rare Earth) rich side composition. On the other hand, a composition having primarily a magnetic moment of a transition metal is referred to as a TM (Transition Metal) rich side. In the phase of a TM rich side, if the phase is not oxidized (preferable phase), the HC (coercive force) becomes large. On the other hand, in the phase of a RE rich side, if the phase is not oxidized (preferable phase), the Hc (coercive force)becomes small.

Thus the phase of a target according to the present invention has a large value of HC in comparison to the phase of a conventional target even if both of them have the same composition.

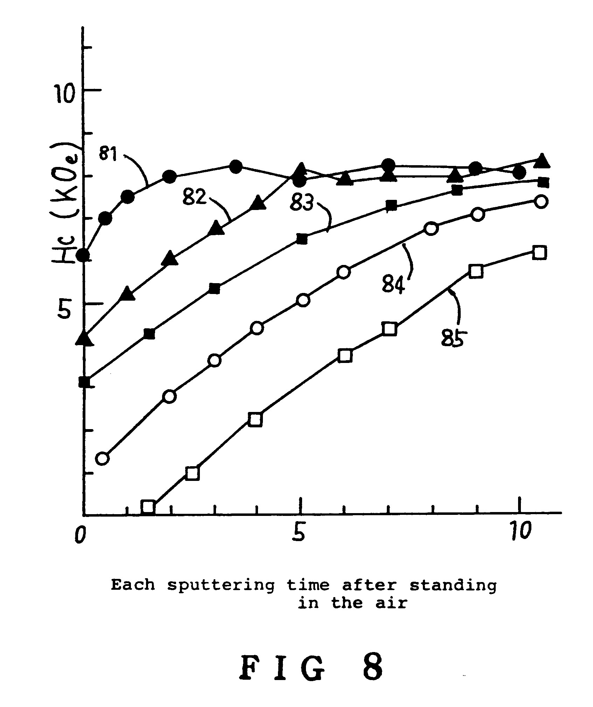

The relationship between the time during which the target obtained by the semi-melting method was exposed to the air and the film characteristic was then examined. After the target had been completely cleaned by pre-sputtering and the film characteristic became stable, the target was removed from the sputtering device and left to stand in the air for 10 minutes, 30 minutes, 1 hour, 5 hours and 10 hours, respectively. Thereafter, an experiment similar to that illustrated in Figure 7 was carried out to examine the dependence of the magnetic characteristic of the film on the sputtering time. The results are shown in Figure 8. The reference numeral 81 denotes the target after standing in the air for 10 minutes, 82 the target after standing in the air for 30 minutes, 83 the target after standing in the air for 1 hour, 84 the target after standing in the air for 5 hours, and 85 the target after standing in the air for 10 hours. As is clear from Figure 8, in the target obtained by the semi-melting method, even if it is left to stand in the air for 10 minutes, the surface is oxidized, thereby influencing the magnetic characteristic of the film. The longer the target is left to stand in the air, the more oxidization from the surface proceeds and the greater is the effect on the magnetic characteristic of the film.

The fact that leaving a target to stand in the air has a deleterious influence on the magnetic characteristic of the film produces a big problem at the time of mass production of magneto-optic recording media in respect of yield and cost. The target of the present invention is, however, very advantageous in this respect.

In producing the medium, PC (polycarbonate) was used for the substrate and AℓSiN for the dielectric film, but the present invention is not restricted thereto. The effects of the present invention were also obtained by using PMMA (polymethylmethacrylate), APO (amorphous polyolefin), glass or the like for the substrate and SiN, Si₃N₄, Si0, AℓN, AℓSiN, ZnS or the like for the dielectric film.

### Example 1-2

An ingot of an alloy of 23 at% of Pr and 77 at% of Tb was prepared as a raw material. A PrTb powder was made in the same way as in Example 1-1. In the same way as in Example 1-1, a powder of an alloy of 80.5 at% of Fe and 19.5 at% of Co was prepared.

Pr, Tb, Fe and Co were charged in powdered form into a crucible in the atomic ratio of 10.0 : 35.0 : 44.0 : 11.0 and were completely melted by heating them to 1,550°C. Thereafter the temperature was lowered to 1,200°C and the PrTb powder and FeCo powder were added to the molten metal of PrTbFeCo alloy in the crucible. Since the melting point of PrTb was 1,370°C and the melting point of FeCo was 1,530°C, both of them existed in the molten metal of 1,200°C in the form of PrTb powder and FeCo powder, respectively, without dissolving therein. The ratio of PrTbFeCo, PrTb and FeCo contents were as follows:-

(PrTbFeCo)_{E} [(PrTb)_{G}(FeCo)_{H}]_{F}

E : F = 25 : 75 wt%
G : H = 28 : 72 at%
A film was formed by using the cast (PrTbFeCo)-(PrTb)-(FeCo) alloy target obtained, a film forming apparatus and a film forming method similar to those described in Example 1-1 being employed. When the magnetic characteristic and the composition distribution of the film on the substrate holder were evaluated, the RE content was uniformly 28.0 to 28.5 at%, and the Hc was uniformly 18.0 to 19.0 KOe. The amount of oxygen was as small as 380 ppm. When the target was used again after standing in the air for 24 hours, the sputtering discharge was stable from the beginning and the magnetic characteristic of the film was also stable from the beginning.

Thus, the effects of the present invention were also confirmed in the PrTbFeCo alloy target.

### Example 1-3

An ingot of an alloy of 23 at% of Sm and 77 at% of Gd was prepared as a raw material. An SmGd powder was made in the same way as in Example 1-1. In the same way as in Example 1-1, a powder of an alloy of 90 at% of Fe and 10 at% of Co was prepared.

Sm, Gd, Fe and Co were charged in powdered form into a crucible in the atomic ratio of 10 : 35 : 49.5: 5.5 and were completely melted by heating them to 1,550°C. Thereafter the temperature was lowered to 1,200°C and the SmGd powder and FeCo powder were added to the molten metal of SmGdFeCo alloy in the crucible. Since the melting point of SmGd was 1,270°C and the melting point of FeCo was 1,530°C, both of them existed in the molten metal of 1,200°C in the form of SmGd powder and FeCo powder, respectively, without dissolving therein. The ratio of SmGdFeCo, SmGd and FeCo contents were as follows.

(SmGdFeCo)_{I}[(SmGd)_{K}(FeCo)_{L}]_{J}

I : J = 25 : 75 wt%
K : L = 28 : 72 at%
A film was formed by using the cast alloy (SmGdFeCo)⁻(SmGd)⁻(FeCo) target obtained, a film forming apparatus and a film forming method similar to those in Example 1-1 being employed.

The target proved to be capable of forming a film on the substrate holder free from non-uniform chemical composition distribution and characteristic distribution. The RE content was uniformly 28.0 to 28.5 at%, and the Hc was uniformly 5 to 5.5 KOe. The amount of oxygen was a small as 300 ppm. When the target was used again after standing for 24 hours in the air, the sputtering discharge was stable from the beginning and the magnetic characteristic of the film was also stable from the beginning.

Thus, the effects of the present invention were also confirmed in the case of the SmGdFeCo alloy target.

### Example 1-4

An ingot of an alloy of 11.5 at% of Ce, 11 at% of Pr and 77 at% of Dy was prepared as a raw material. A CePrDy powder was made in the same way as in Example 1-1. In the same way as in Example 1-1, a powder of an alloy of 80.5 at% of Fe and 19.5 at% of Co was prepared. Ce, Pr, Dy, Fe and Co were charged in powdered form into a crucible in the atomic ratio of 5.0 : 5.0 : 35.0 : 44.0 : 11.0 and were completely melted by heating them to 1,550°C. Thereafter the temperature was lowered to 1,200°C and the CePrDy powder and the FeCo powder were added to the molten CePrDyFeCo in the crucible. Since the melting point of CePrDy was 1,350°C and the melting point of FeCo was 1,530°C,both of them existed in the molten metal of 1,200°C in the form of CePrDy powder and FeCo powder, respectively, without dissolving therein. The ratio of CePrDyFeCo, CePrDy and FeCo contents were as follows:-

(CePrDyFeCo)_{M} [(CePrDy)_{P}(FeCo)_{L}]_{N}

M : N = 25 : 75 wt%
P : Q = 28 : 72 at%
A film was formed by using the cast alloy (CePrDyFeCo)-(CePrDy)-(FeCo) target obtained, a film forming apparatus and a film forming method similar to those in Example 1-1 being employed. The target proved to be capable of forming a film on the substrate holder free from non-uniform composition distribution and characteristic distribution as in the case of the targets obtained in Examples 1-1, 1-2, and 1-3. The amount of oxygen was as small as 420 ppm. When the target was used again after standing for 24 hours in the air, the sputtering discharge was stable from the beginning and the magnetic characteristic of the film was also stable from the beginning.

Thus, the effects of the present invention were also confirmed in the case of the CePrDyFeCo alloy target.

It was confirmed that the effects of the present invention also exist in relation to the other compositions containing at least one light rare earth element selected from the group consisting of Sm, Nd, Pr and Ce, at least one heavy rare earth element selected from the group consisting of Gd, Tb and Dy and at least one transition metal selected from the group consisting of Fe and Co, such as NdTbFeCo, NdGdFeCo, NdDyTbCo, NdTbGdFe, NdTbGdFeCo, NdDyGdFeCo. NdDyGdTbFeCo, PrDyFeCo, PrGdFeCo, NdPrDyFeCo, NdCeDyFeCo, NdTbCo, NdPrCeDyFeCo, NdSmDyFeCo, CeSmPrDyFeCo, CePrNdDyTbFeCo and CeNdPrDyGdFeCo as well as the compositions shown in Examples 1-1, 1-2, 1-3, and 1-4.

Another embodiment of the present invention in which the target composition does not contain a light rare earth metal, in other words, contains only a heavy rare earth metal (HR) and a transition metal (TM) will now be described.

### Example 2-1

A Tb powder having an average particle diameter of about 300 µm was first prepared as a raw material. An ingot of an alloy of 93 at% of Fe and 7 at% of Co was pulverized into an FeCo powder having an average particle diameter of about 150 µm.

Tb, Fe and Co were charged in powdered form into a crucible in vacuo in the atomic ratio of 45 : 51 : 4 and were completely melted by heating them to 1,650°C. Thereafter the temperature was lowered to 1,200°C and the Tb powder and FeCo powder were added to the molten TbFeCo in the crucible. Since the melting point of Tb was 1,450°C and the melting point of FeCo was 1,530°C, both of them existed in the molten metal of 1,200°C in the form of Tb powder and FeCo powder, respectively, without dissolving therein. The ratio of TbFeCo, Tb and FeCo contents were as follows:

(TbFeCo)_{A} [(Tb_{C}(FeCo)_{D})]_{B}

A : B = 25 : 75 wt%
C : D = 22 : 78 at%
The thus-obtained molten (TbFeCo)Tb(FeCo) was cast into a mould, and the cast alloy was machined to obtain a sputtering target of 4" φ x 6t. The surface structure of the thus-obtained sputtering target is similar to that shown in Figure 1. The surface structure was composed of an RE single phase of Tb, a TM single phase of FeCo and an RE-TM alloy phase of TbFeCo.

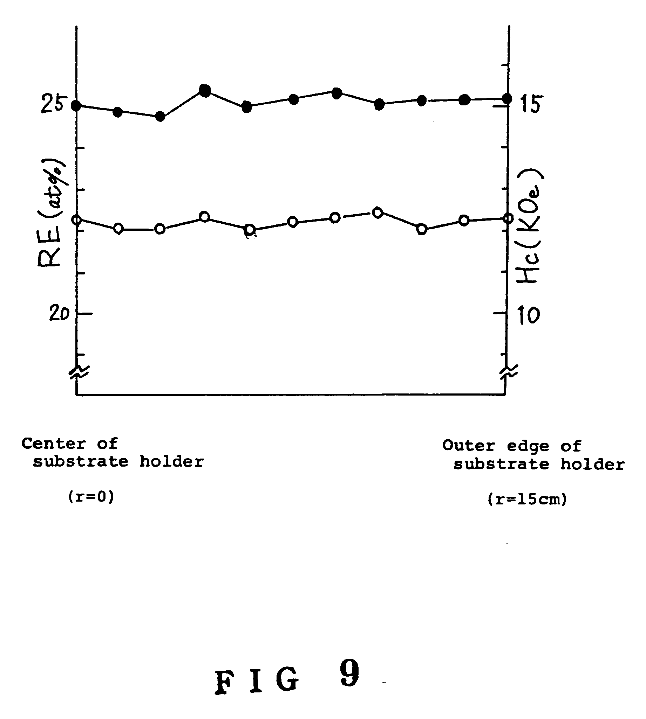

The TbFeCo target so produced was mounted on the sputtering device shown in Figure 2 for film formation and the magnetic characteristic and the chemical composition distribution of the film were examined. The film forming conditions were that the Argon pressure was 2.5 mTorr, the initial vacuum was 3 x 10⁻⁷ Torr, and the current employed was 1.0 A at 340 V from a DC power source. Figure 9 shows the chemical composition distribution and the magnetic characteristic distribution of a film produced on the substrate holder in the case of using the target of the present invention described above. As shown in Figure 9, in the case of the chemical composition, the RE content is uniformly 22.0 to 22.5 at%, and in the case of the magnetic characteristic the Hc is uniformly 14.7 to 15.5 KOe. Thus, a substantially uniform film was formed on the substrate holder. Since this target was made of a cast alloy, the amount of oxygen was naturally as small as 350 ppm.

A magneto-optic recording medium was produced by sputtering by the use of the target of the present invention, described above. The C/N ratio of the thus-obtained medium was as high as 60 dB at a linear velocity of 5.7 m/sec and a Domain length of 1.4 µm. In a reliability test of the medium, no pitting corrosion was produced for as long as 3,000 hours at a constant temperature of 90°C and at a constant relative humidity of 90%, and an increase in error rate was not observed.

For comparison, a TbFeCo target was manufactured by a known method. The whole composition of a TbFeCo alloy consisting of 22 at% of Tb, 73 at% of Fe and 5 at% of Co was dissolved in a crucible at 1,650°C, and poured into a mould to produce an ingot. The ingot was cut and ground to produce a TbFeCo target of 4" φ x 6 t.

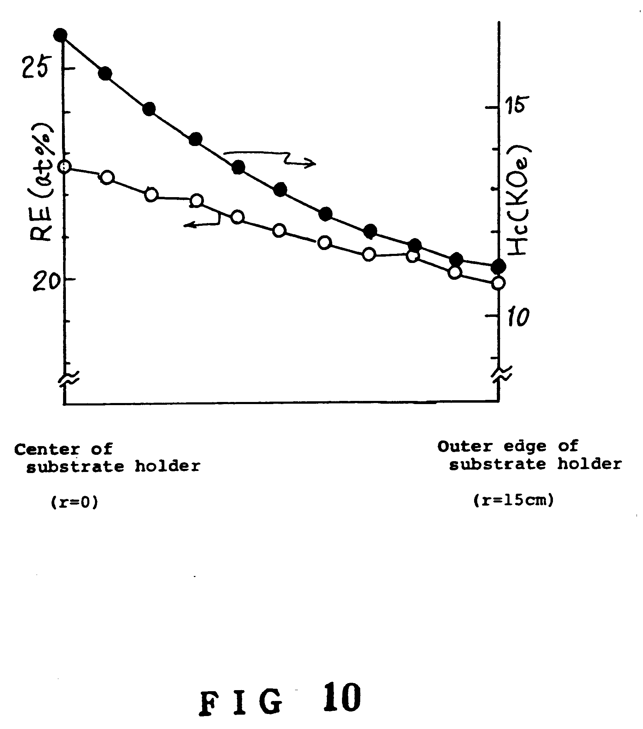

Figure 10 shows the chemical composition distribution and the magnetic characteristic distribution on the film on the substrate holder in the case of using the cast TbFeCo target obtained in the known method. As shown in Figure 10, in the composition, the RE content is 22.8 to to 19.8 at%, and the closer to the centre of the substrate holder, the greater is the RE content, while the closer to the outer periphery of the holder, the smaller is the RE content. In the case of the magnetic characteristics, the Hc is 17 to 11 KOe. Namely, the closer to the centre of the holder, the greater is the Hc. This tendency agrees with the composition distribution. In other words, in the TbFeCo target obtained by the known casting method,there is a tendency for there to be TM sputtering upwardly from the target and RE sputtering in the horizontal direction, so that a non-uniform chemical composition distribution is produced on the substrate holder.

A magneto-optic recording medium was produced by sputtering by the use of the known target. The C/N ratio of the medium was a little low, namely 57 dB at a linear velocity of 5.7 m/sec and a Domain length of 1.4 µm. This is due to the influence of the composition distribution in the medium. In a reliability test of the medium, no pitting corrosion was produced for as long as 3,000 hours at a constant temperature of 90°C and at a constant relative humidity of 90%.

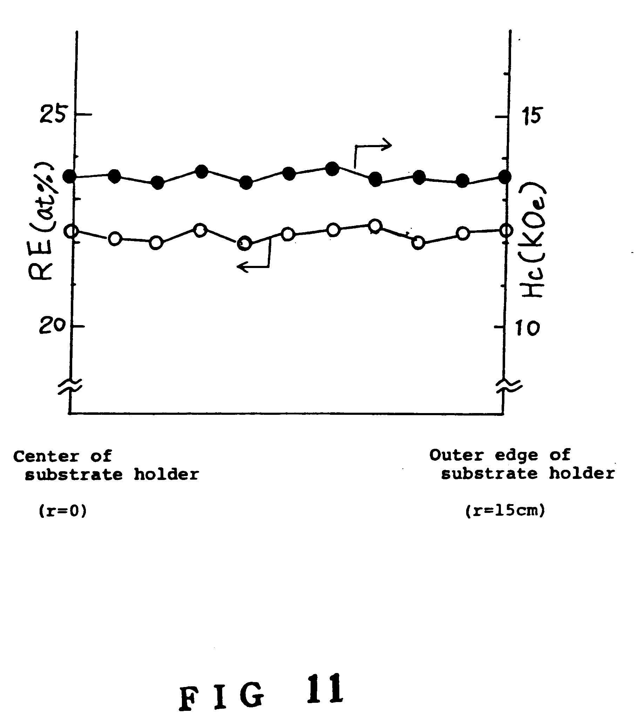

For further comparison, a TbFeCo alloy target was manufactured by a semi-melting method as described in Japanese Patent Laid-Open Specifications Nos. 95788/1986 and 99640/1986 and the film formed thereby was evaluated. The target composition was 22 at% of Tb, 73 at% of Fe and 5 at% of Co. The contents of Tb, TbFeCo and FeCo were the same as above. The amount of oxygen in the target was 1,300 ppm. The target was mounted on the sputtering device shown in Figure 2, and after the surface of the target was sufficiently cleaned by pre-sputtering, a film was formed. The film forming conditions were the same as above. Figure 11 shows the chemical composition distribution and the magnetic characteristic distribution on a film on the substrate holder in the case of using the TbFeCo target obtained in the semi-melting method. The chemical composition distribution is almost the same as that shown in Figure 9 in the case of using the target of the present invention, but the magnetic characteristic distribution moves toward the smaller coercive force (Hc). This phenomenon was caused because the target obtained by the semi-melting method was a sintered body, so that the amount of oxygen was larger than that in the target of the present invention and the rare earth metal had been partially oxidized.

A magneto-optic recording medium was produced by sputtering by the use of the target obtained by the semi-melting method. The C/N ratio of the medium was a little low, namely 58 dB at a linear velocity of 5.7 m/sec and a Domain length of 1.4 µm. This was because the oxygen in the target had entered the film. In a reliability test of the medium, a pitting corrosion was produced when 200 hours had passed at a constant temperature of 90°C and at a constant relative humidity of 90%, and the error rate began to deteriorate. This is also because the oxygen in the target had entered the film.

The TbFeCo target of the present invention and the TbFeCO target obtained by the semi-melting method were removed from the sputtering device after the end of sputtering, and both targets were left to stand in the air for 24 hours. Thereafter both targets were mounted again on the sputtering device shown in Figure 2 for film formation. The discharging state at the time of sputtering is shown in Table 2.

**TABLE 2**

| | Target according to the present invention | Target obtained by the semi-melting method |
|---|---|---|
| Beginning of sputtering | DC sputtering; Argon pressure: 2/5 mTorr stable discharge | RF sputtering; discharged with difficulty at Argon pressure of 8 mTorr |
| 1 hour after sputtering | Same as above | DC sputtering; discharged with difficulty at Argon pressure of 8 mTorr |
| 2 hours after sputtering | Same as above | DC sputtering; discharged at Argon pressure of 2.5 mTorr, but unstable discharge |
| 5 hours after sputtering | Same as above | DC sputtering; discharged at Argon pressure of 2.5 mTorr and stable discharge obtained with difficulty |

As shown in Table 2, while the target of the present invention was capable of stable discharge from the beginning at a constant Argon pressure of 2.5 mTorr, the target obtained by the semi-melting method was not capable of DC sputtering at the beginning of sputtering. This was because the target had been left to stand for a long time in the air, thereby making the surface of the target obtained by the semi-melting method completely insulating. In 1 hour, this target enabled DC sputtering to be effected, but an Argon pressure of 8 mTorr was required. It was not until 5 hours after the beginning of discharge that the target enabled DC sputtering to be effected at an Argon pressure of 2.5 mTorr.

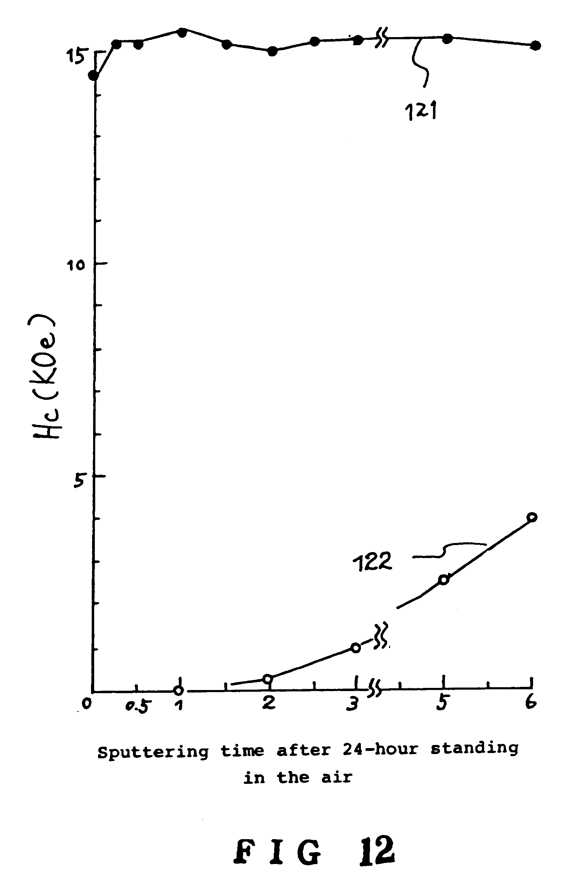

The relationships between the sputtering time and the magnetic characteristic of the film in the case of using these targets after they have stood in the air are shown in Figure 12. The reference numeral 121 denotes the target of the present invention as described above and 122 the target obtained by the semi-melting method. As is clear from Figure 12, the target of the present invention, which had been exposed to the air for a long time, exhibited a stable film characteristic immediately after sputtering. On the other hand, when the target obtained by the semi-melting method had been exposed to the air for a long time, the initial sputtering itself became very difficult, and the film characteristic did not become stable at all even after a long period of pre-sputtering. When the film characteristic became stable, the target had almost been consumed. Since the magnetic characteristic of the film is on the TM-rich side of a said compensation composition, the larger the coercive force (Hc), the better.

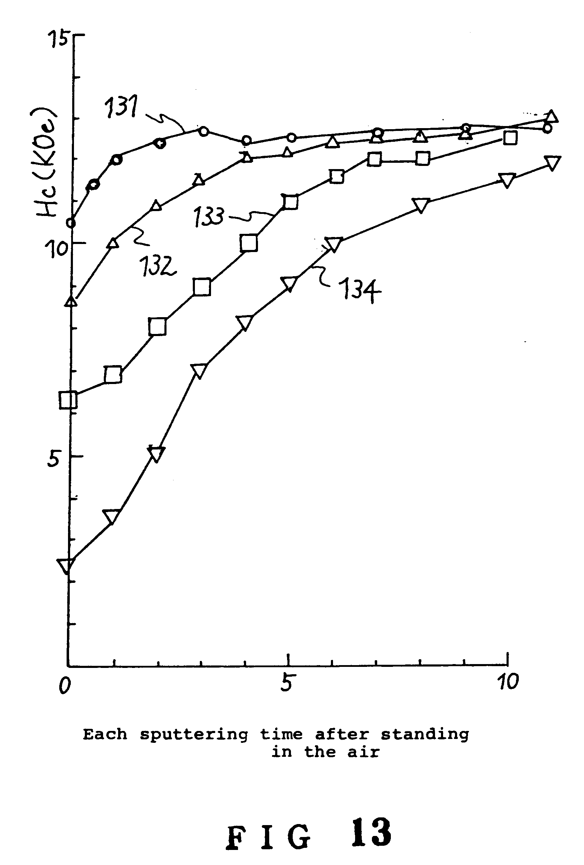

The relationship between the time for exposing to the air the target obtained by the semi-melting method and the film characteristic thereof was then examined. After the target had been completely cleaned by pre-sputtering and the film characteristic became stable, the target was removed from the sputtering device and left to stand in the air for 10 minutes, 30 minutes, 1 hour and 3 hours, respectively. Thereafter, an experiment similar to that shown in Figure 12 was carried out to examine the dependence of the magnetic characteristic of the film on the sputtering time. The results are shown in Figure 13. The reference numeral 131 denotes the target after standing in the air for ten minutes, 132 denotes the target after standing in the air for 30 minutes, 133 the target after standing in the air for 1 hour and 134 the target after standing in the air for 3 hours. As is clear from Figure 13, in the target obtained by the semi-melting method, when it is left to stand in the air even for 10 minutes, the surface is oxidized, thereby influencing the magnetic characteristic of the film. The longer the target is left to stand in the air, the more the oxidization from the surface proceeds and the more the magnetic characteristic of the film is influenced.

The effects of the present invention were thus also confirmed in a TbFeCo target which contains no light rare earth metal.

### Example 2-2

A Dy powder having an average particle of about 300 µm was first prepared as a raw material. An ingot of an alloy of 93 at% of Fe and 7 at% of Co was pulverized into an FeCo powder having an average particle diameter of about 150 µm.

Dy, Fe, and Co in powdered form were charged into a crucible in vacuo in the atomic ratio of 45 : 51 : 4 and were completely melted by heating them to 1,650°C. Thereafter, the temperature was lowered to 1,200°C and the Dy powder and FeCo powder were added to the molten DyFeCo in the crucible. Since the melting point of Dy was 1,450°C and the melting point of FeCo was 1,530°C, both of them existed in the molten metal of 1,200°C in the form of Dy powder and FeCo powder, respectively, without dissolving therein. The ratio of DyFeCo, Dy and FeCo contents were as follows:

(DyFeCo)_{E} [Dy_{G}(FeCo)_{H}]_{F}

E : F = 25 : 75 wt%
G : H = 28 : 72 at%
The thus-obtained molten (DyFeCo)Dy(FeCo) alloy was cast into a mould, and the cast alloy was machined to obtain a sputtering target of 4" φ x 6t. A film was formed by using this target, a film forming apparatus and a film forming method similar to those described in Example 2-1 were employed. When the magnetic characteristic and the composition distribution of the film on the substrate holder were evaluated, the RE content was uniformly 22.0 to 22.5 at%, and the Hc was uniformly 12.0 to 13.0 KOe. The amount of oxygen was as small as 350 ppm. Even if the target was used again after standing for 24 hours in the air, the sputtering discharge was stable from the beginning and the magnetic characteristic of the film was also stable from the beginning.

Thus the effects of the present invention were also confirmed in the case of the DyFeCo target.

### Example 2-3

An ingot of an alloy of 50 at% of Tb and 50 at% of Gd was prepared as a raw material and a GdTb powder was formed. Similarly, a powder of an alloy of 93 at% of Fe and 7 at% of Co was prepared. Gd, Tb, Fe and Co were charged in powdered form into a crucible in the atomic ratio of 22.5 : 22.5 : 51 : 4 and were completely melted by heating them to 1,650°C. Thereafter the temperature was lowered to 1,200°C and the GdTb powder and FeCo powder were added to the molten GdTbFeCo in the crucible. Since the melting point of GdTb was 1,400°C and the melting point of FeCo was 1,530°C, each of them existed in the molten metal of 1,200°C in the form of GdTb powder and FeCo powder, respectively, without dissolving therein. The ratio of the GdTbFeCo, GdTb and FeCo contents were as follows:

(GdTbFeCo)_{I} [(GdTb)_{K}(FeCo)_{L}]_{J}

1 : J = 25 : 75 wt%
K : L = 22 : 78 at%
The cast (GdTbFeCo)-(GdTb)-(FeCo) target so obtained proved to be capable of forming a film on the substrate holder free from non-uniform chemical composition distribution and characteristic distribution like the targets obtained in Examples 2-1 and 2-2. The RE content was uniformly 22 to 22.5 at% and the Hc was uniformly 11 to 13 KOe. The amount of oxygen was as small as 300 ppm.

When the target was used again after standing for 24 hours in the air, the sputtering discharge was stable from the beginning,and the magnetic characteristic of the film was also stable from the beginning.

Thus, the effects of the present invention were also confirmed in the case of the GdTbFeCo target.

It was confirmed that the effects of the present invention also exist in targets of other compositions containing at least one heavy rare earth element selected from the group consisting of Gd, Tb and Dy and at least one transition metal selected from the group consisting of Fe and Co, such as TbDyFeCo, DyGdFeCo, GdFeCo, GdTbFe, TbDyFe, TbCo, and DyGdCo as well as the compositions shown in Examples 2-1, 2-2 and 2-3.

An embodiment of a method of manufacturing a target according to the present invention will now be explained. This method is called an impregnation method. This manufacturing method will be briefly explained.

A TM powder is charged into a mould and an ingot of an RE-TM alloy (hereinunder referred to as a "master alloy") is placed on the TM powder. The composition of the master alloy is, in the vicinity of the eutectic, closer to the rare earth metal side in the phase diagram. The master alloy is a low-melting point alloy having a melting point not higher than 1,200°C. The TM powder and the master alloy are heated to melt the master alloy so as to cause it to infiltrate into the pores of the powder. Since the master alloy is separated into an RE phase and an RE₁ TM₂ phase when it solidifies, the metal structure of the target produced naturally has three phases, namely,a TM phase, an RE phase and RE-TM alloy phase.

### Example 3-1

An ingot of an alloy of 72.2 at% of (Nd_{0.2}Dy_{0.8}) and 27.8 at% of (Fe_{0.8}Co_{0.2}) was first prepared as a raw material (this ingot will be referred to as "R + R₁T₂ master alloy" hereinunder). The melting point of the master alloy was low as about 830°C and it was in the form of a block of 4" φ x 2t. A powder of an alloy of 80 at% of Fe and 20 at% of Co having a particle diameter of 200 µm was next prepared. The melting point of the powder was as high as about 1,500°C and the porosity thereof was 62.4%.

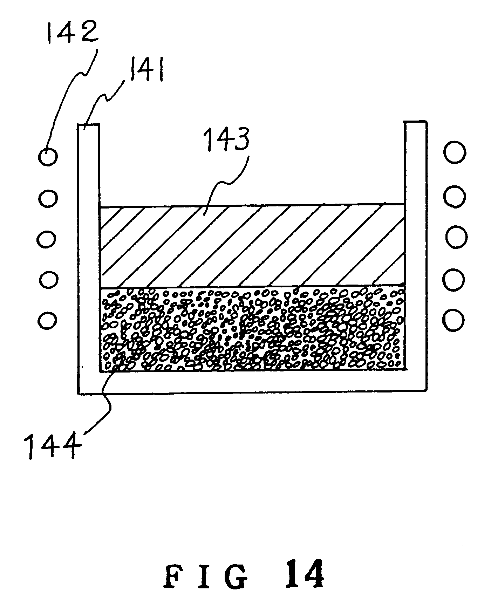

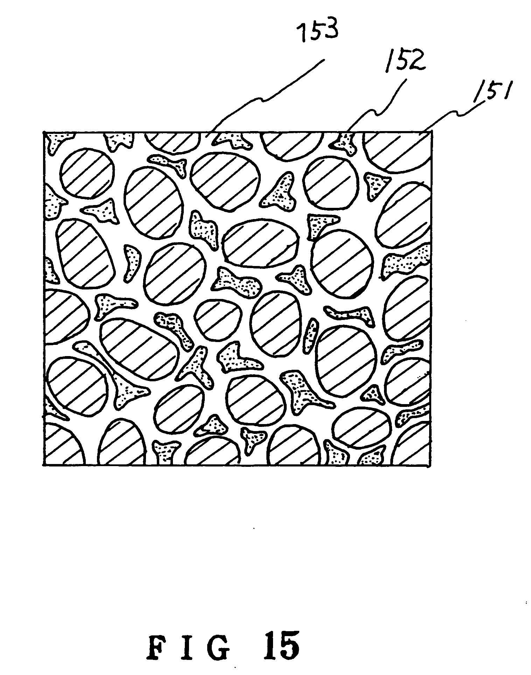

The powder was charged into a crucible 4" φ in inner diameter and the R + R₁T₂ master alloy was placed thereon. This state is schematically shown in Figure 14. The reference numeral 141 represents the crucible, 142 a high-frequency induction heating coil, 143 the R + R₁T₂ master alloy, and 143 the Fe-Co alloy powder. In this state, the crucible 141 was evacuated and thereafter the temperature was raised to 1,050°C in the non-pressurized state. At this time, the R + R₁T₂ master alloy had been melted but the Fe-Co powder was not molten and existed in the form of the powder. That is, the molten metal of the ingot of R + R₁T₂ master alloy infiltrated into the pores of the Fe-Co powder, thereby filling up the pores. Thereafter, the crucible was cooled and the moulded product was removed from the crucible. The moulded product was machined and ground so as to produce a sputtering target of 4" φ x 3t. In the composition of the thus-obtained target, Nd was 5.5 at%, Dy 22.0 at%, Fe 58.0 at% and Co 14.5 at%. The surface structure of the target is schematically shown in Figure 15. The reference numeral 151 denotes a phase of Fe-Co particles, 152 a rare earth single phase of Nd-Dy and 153 a rare earth transition metal alloy phase of (NdDy)₁(FeCo)₂. That is, the surface structure was composed of three phases consisting of a rare earth single phase, a rare earth transition metal alloy phase and a transition metal single phase.

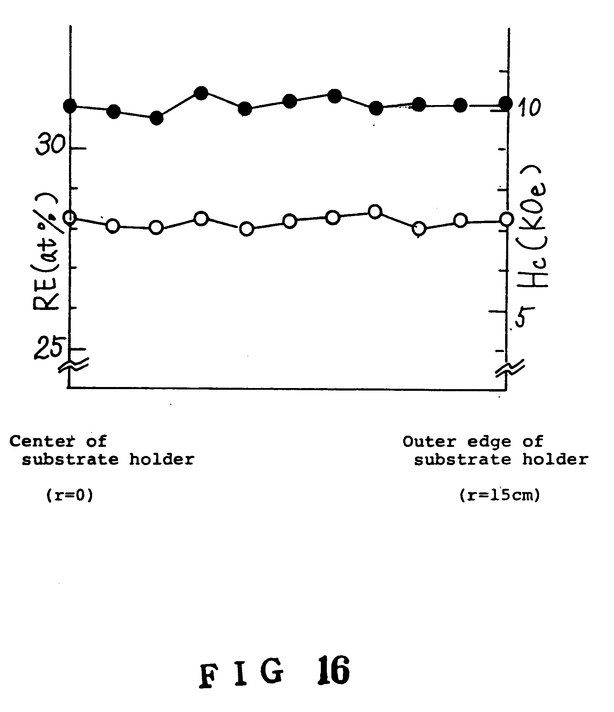

The so obtained NdDyFeCo target was mounted on a sputtering device such as that shown in Figure 2 for film formation and the magnetic characteristic and the composition distribution of the film were examined. The film forming conditions were that the Argon pressure was 2.5 mTorr, the initial vacuum was 3 x 10⁻⁷ Torr, and the current employed was 1.0 A at 340 V from a DC power source. Figure 16 shows the chemical composition distribution and the magnetic characteristic distribution of a film on the substrate holder in the case of using the target obtained by the method of this embodiment. As shown in Figure 16, in the case of the chemical composition, the RE content is uniformly 28.0 to 28.5 at%, and in the case of the magnetic characteristics,the Hc is uniformly 9.7 to 10.5 KOe, thereby showing a magnetic characteristic which agrees with the film composition. Thus, a substantially uniform film was formed on the substrate holder. Since the master alloy of the target is not a powder but in bulk form, and the target was produced not by a sintering method but by a complete impregnation method, the amount of oxygen was naturally as small as 350 ppm. In addition, since the method of pouring a molten metal into a mould was not adopted for manufacturing the target, production of a cavity is rare and the packing density was as high as 99.5%.

In this target, the discharge was also stable from the start of sputtering, and DC sputtering was possible at an Argon pressure of 2.5 mTorr. The target showed a stable film characteristic immediately after sputtering after standing in the air for 24 hours.

### Example 3-2

The effects of the present invention in relation to a target employing PrTbFeCo were examined. In the same way as in Example 3-1, an ingot of a master alloy of 80 at% of (Pr_{0.2}Tb_{0.8}) and 20 at% of (Fe_{0.8}Co_{0.2}) was first prepared as a raw material. The melting point of the master alloy was about 810°C and the alloy was in the form of a block of 4" φ x 2.5t. A powder of an alloy of 80 at% of Fe and 20 at% of Co having a particle diameter of 200 µm was next prepared. The powder was charged into an alumina mould of 4" φ in inner diameter and the master alloy was placed thereon. The mould was heated to 1,050°C in vacuo in the non-pressurized state in an oven. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Pr was 5.5 at%, Tb 22.0 at%, Fe 58.0 at% and Co 14.5 at%. When evaluation was effected of the magnetic characteristic and of the chemical composition distribution of the film on the substrate holder which had been formed by using a film forming apparatus and a film forming method similar to those in Example 3-1, the RE content was uniformly 28.0 to 28.5 at%, and the Hc was uniformly 18.0 to 19.0 KOe. The amount of oxygen was as small as 380 ppm. When the target was used again after standing in the air for 24 hours, the sputtering discharge was stable from the beginning and the magnetic characteristic of the film was also stable from the beginning.

Thus, it was confirmed that this method was usable in relation to a PrTbFeCo composition and that the same effects were obtained.

### Example 3-3

The effects of the present invention in relation to a target employing SmGdFeCo were examined. In the same way as in Examples 3-1 and 3-2, an ingot of a master alloy of 72.2 at% of (Sm_{0.2}Gd_{0.8}) and 27.8 at% of (Fe_{0.8}Co_{0.2}) was first prepared as a raw material. The melting point of the master alloy was about 808°C. A powder of an alloy of 80 at% of Fe and 20 at% of Co having a particle diameter of 200 µm was next prepared. The powder was charged into a mullite mould of 4" φ in inner diameter, and the master alloy was placed thereon. The mould was heated to 1,040°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Sm was 5.5 at%, Gd 22.0 at%, Fe 58.0 at% and Co 14.5 at%. When evaluation was effected of the magnetic characteristic and the chemical composition distribution of the film on the substrate holder which had been formed by using a film forming apparatus and a film forming method similar to those in Examples 3-1 and 3-2, the RE content was uniformly 28.0 to 28.5 at%, and the Hc was uniformly 5 to 5.5 KOe. The amount of oxygen was as small as 390 ppm. When the target was used again after standing for 24 hours in the air, the sputtering discharge was stable from the beginning and the magnetic characteristic of the film was also stable from the beginning.

Thus, it was confirmed that this method was usable in relation to an SmGdFeCo composition and that the same effects were obtained.

### Example 3-4

The effects of the present invention in relation to a target employing NdSmDyTbFeCo were examined. In the same way as in Examples 3-1, 3-2, and 3-3, an ingot of a master alloy of 72.2 at% of (Nd_{0.1}Sm_{0.1}Dy_{0.4}Tb_{0.4}) and 27.8 at% of (Fe_{0.8}Co_{0.2}) was first prepared as a raw material, The melting point of the master alloy was about 830°C and the alloy was in the form of a block of 4" φ x 2.5. A powder of an alloy of 80 at% of Fe and 20 at% of Co having a particle diameter of 200 µm was next prepared. The powder was charged into an isolite mould of 4" φ in inner diameter, and the master alloy was placed thereon. The mould was heated to 1,030°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Nd was 2.75 at%, Sm 2.75 at%, Dy 11.0 at%, Tb 11.0 at%, Fe 58.0 at% and Co 14.5 at%. When evaluation was effected of the magnetic characteristic and the chemical composition distribution of the film on the substrate holder which had been formed by using a film forming apparatus and a film forming method similar to those in Examples 3-1, 3-2 and 3-3, the RE content was uniformly 28.0 to 28.5 at%, and the Hc was uniformly 17 to 17.5 KOe. The amount of oxygen was as small as 375 ppm. Even when the target was used again after standing in the air for 24 hours, the sputtering discharge was stable from the beginning.

Thus, it was confirmed that this method was usable in relation to an NdSmDyTbFeCo composition and that the same effects were obtained.

It was also confirmed that this method can be used with the same effects in relation to other compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as NdTbFeCo, NdPrDyFeCo, NdPrDyTbFeCo, PrDyFeCo, NdSmGdFeCo, CeNdDyFeCo and CeNdPrDyFeCo as well as the compositions shown in Examples 3-1, 3-2, 3-3 and 3-4.

It was also confirmed that it is possible to have a desired Co composition by adjusting the Co content in the master alloy while using an Fe powder as the transition metal.

An embodiment of a target which contains no light rare earth metal, namely, which contains a heavy rare earth metal and a transition metal, will now be described.

### Example 3-5

An ingot of a master alloy of 72 at% of Tb and 28 at% of (Fe_{0.9}Co_{0.1}) was first prepared as a raw material (this ingot will be referred to as "R + R₁T₂ master alloy" hereinunder). The melting point of the master alloy was as low as about 847°C and the alloy was in the form of a block of 4" φ x 2.5t. A powder of an alloy of 90 at% of Fe and 10 at% of Co having a particle diameter of 200 µm was next prepared. The melting point of the powder was as high as 1,500°C and the porosity thereof was 43.3%.

The powder was charged into an alumina mould of 4" φ in inner diameter and the master alloy was placed thereon. The mould was heated to 1,020°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the composition of the target, Tb was 22.0 at%, Fe 70.2 at% and Co 7.8 at%. When evaluation was effected of the magnetic characteristic and the chemical composition distribution of the film on the substrate holder which had been formed by using a film forming apparatus and a film forming method similar to those in Examples 3-1, 3-2, etc., the RE content was uniformly 22.0 to 22.5 at%, and the Hc was uniformly 14.7 to 15.5 KOe. Thus, a substantially uniform film was formed on the substrate holder. The amount of oxygen was as small as 350 ppm. Even when the target was used again after standing in the air for 24 hours, the sputtering discharge was stable from the beginning and the magnetic characteristic of the film was also stable from the beginning.

### Example 3-6

The effects of the present invention in relation to a target employing DyFeCo were examined. In the same way as in Examples 3-1, 3-2, etc. an ingot of a master alloy of 71.5 at% of Dy and 28.5 at% of (Fe_{0.9}Co_{0.1}) was first prepared as a raw material. The melting point of the master alloy was about 890°C. A powder of an alloy of 90 at% of Fe and 10 at% of Co having a particle diameter of 200 µm was next prepared. The melting point of the powder was as high as 1,500°C and the porosity therof was 43.2%.

The powder was charged into a mullite mould of 4" φ in inner diameter and the master alloy was placed thereon. The mould was heated to 1,050°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Dy was 22.0 at%, Fe 70.2 at% and Co 7.8 at%. When evaluation was effected of the magnetic characteristic and the chemical composition distribution of the film on the substrate holder which had been formed by using a film forming apparatus and a film forming method similar to those in Examples 3-1, 3-2, etc., the RE content was uiformly 21.5 to 22.0 at%, and the Hc was uniformly 13.5 to 13.0 KOe. Thus, a substantially uniform film was formed on the substrate holder. The amount of oxygen was as small as 350 ppm. When the target was used again after standing in the air for 24 hours, the sputtering discharge was stable from the beginning and the magnetic characteristic of the film was also stable from the beginning.

### Example 3-7

The effects of the present invention in relation to a target employing TbGdFeCo were examined. In the same way as in Examples 3-1, 3-2 etc, an ingot of a master alloy of 71.5 at% of (Tb_{0.5}Gd_{0.5}) and 28.5 at% of (Fe_{0.9}Co_{0.1}) was first prepared as a raw material. The melting point of the master alloy was about 838°C. A powder of an alloy of 90 at% of Fe and 10 at% of Co having a particle diameter of 200 µm was next prepared. The melting point of the powder was as high as 1,500°C and the porosity thereof was 43.7%.

The powder was charged into an isolite mould of 4" φ in inner diameter and the master alloy was placed thereon. The mould was heated to 1,050°C in vacuo in the non-pressurized state. After the master alloy was melted, the mould was cooled. The moulded product removed from the mould was machined and ground so as to produce a sputtering target of 4" φ 3t. The surface structure of the thus-obtained target was composed of three phases conxsisting of an RE phase, an RE-TM alloy phase and a TM phase. In the case of the composition of the target, Tb was 11.0 at%, Gd 11 at%, Fe 70.2 at% and Co 7.8 at%. When evaluation was effected of the magnetic characteristic and the chemical composition distribution of the film on the substrate holder which had been formed by using a film forming apparatus and a film forming method similar to those in Examples 3-1, 3-2 etc., the RE content was uniformly 22.0 to 22.3 at% and Hc was uniformly 15.5 to 16.0 KOe. Thus a substantially uniform film was formed on the substrate holder. The amount of oxygen was as small as 300 ppm. When the target was used again after standing in the air for 24 hours, the sputtering discharge was stable from the beginning and the magnetic characteristic of the film was also stable from the beginning.

It was confirmed that this method can be used with the same effects in relation to other compositions containing at least one heavy rare earth element selected from the group consisting of Gd, Tb and Dy and at least one transition metal selected from the group consisting of Fe and Co, such as TbFe, TbCo, GdFeCo, GdDyFeCo, GdDyTbFeCo, GdTbFe, DyCo, TbGdCo and TbDyCo, as well as the compositions shown in Examples 3-5, 3-6 and 3-7.
It was also confirmed that it is possible to have a desired Co composition by adjusting the Co content in the master alloy while using an Fe powder as the transition metal powder.

Another method of making a target according to the present invention will now be described. This method is fundamentally the same as the above-described impregnation method, but a foamed TM is used in place of a TM powder. The foamed TM is a porous metal with a spongy skeleton and having a high porosity, as described in, for example, "Kogyo Zairyo", Oct., 1987.

A foamed TM is charged into a mould, and an RE-TM master alloy is placed thereon. The composition of the master alloy in the vicinity of the eutectic, is closer to the rare earth metal side in the phase diagram. The master alloy is a low-melting point alloy having a melting point not higher than 1,200°C. The TM powder and the master alloy are heated to dissolve the master alloy so as to infiltrate it into the pores of the powder. Since the master alloy is separated into an RE phase and an RE₁TM₂ phase when it solidifies, the metal structure of the target produced naturally has three phases, namely, a TM phase, an RE phase and RE-TM alloy phase. Since the TM material for this target is not a powder but a foamed TM, continuous TM constitutes the skeleton of the target. Consequently, the target produced has an increased strength and a reinforced toughness due to the TM skeleton.

### Example 4-1

An ingot of a master alloy of 72 at% of Tb, 26.2 at% of Fe and 1.8 at% of Co was first prepared as a raw material. A foamed sheet of an alloy of 93.6 at% of Fe and 6.4 at% of Co was next prepared. Since the porosity of the foamed sheet was 91%, in other words, too high to be usable as it was, the foamed sheet was pressed so as to have a porosity of 43.5%.

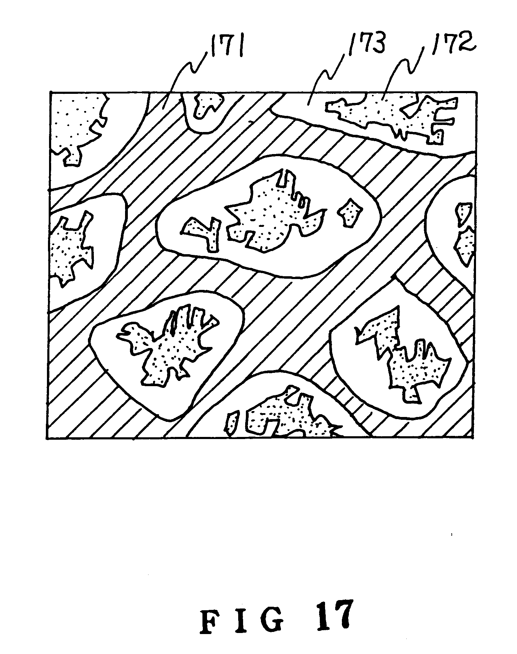

The thus-obtained foamed sheet was charged into an alumina mould of 4" φ in inner diameter and the master alloy was placed thereon. The mould was heated to 1,000°C in vacuo in the non-pressurized state. The master alloy had a melting point of as low as 850°C and the molten master alloy permeated the foamed FeCo sheet. After the master alloy was melted, the mould was cooled. The moulded product removed from the mould was machined and ground so as to produce a sputtering target of 4" φ x 3t. The surface structure of the thus-obtained target is schematically shown in Figure 17. The surface has a mixed structure of a transition metal (Fe_{93.6}Co_{6.4}) single phase 171, a rare earth metal (Tb) single phase 172 and an alloy phase 173 of a transition metal and of a rare earth metal (TbFeCo). In the case of the chemical composition of the target, Tb was 22 at%, Fe 73 at% and Co 5 at%.

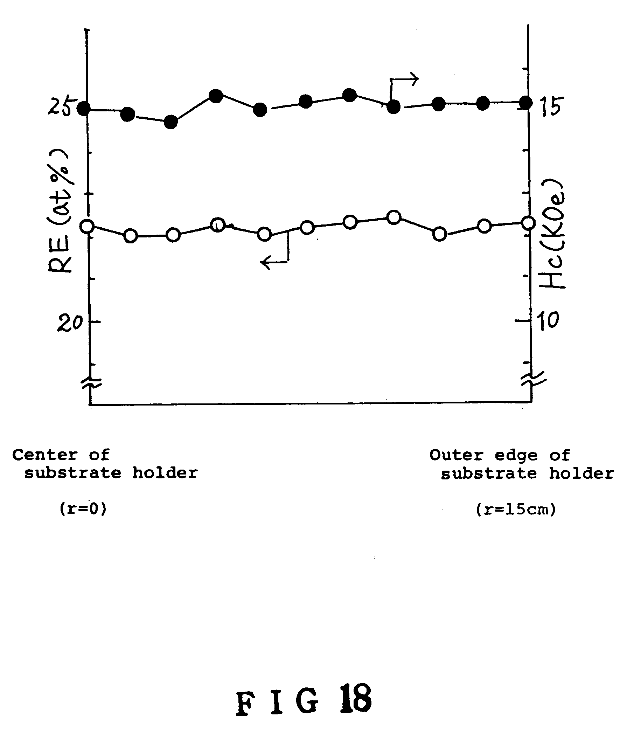

The target of the present invention was mounted on a sputtering device such as that shown in Figure 2 for film formation, and the magnetic characteristic and the chemical composition distribution were examined. The film forming conditions were that the Argon pressure was 2.5 mTorr, the initial vacuum degree was 3 x 10⁻⁷ Torr, and the current used was 1.0 A at 340 V from a DC power source. Figure 18 shows the chemical composition distribution and the magnetic characteristic distribution on the substrate holder in the case of using the target of this example. As shown in Figure 18, in the case of the composition, the RE content is uniformly 22.0 to 22.5 at%, and in the case of the magnetic characteristics, the Hc is uniformly 14.7 to 15.5 KOe. Thus, a substantially uniform film was formed on the substrate holder. Since the target is not a sintered body, neither the master alloy of the target nor the sheet is a powder, and the target was produced by a complete impregnation method, the amount of oxygen naturally being as small as 500 ppm. In addition, the packing density was 99.8%, in other words, packing was substantially perfect.

In this target, discharge was also stable from the start of sputtering, and DC sputtering was possible at an Argon pressure of 2.5 mTorr. The target showed a stable film characteristic immediately after sputtering after standing in the air for 24 hours.

### Example 4-2

An ingot of a master alloy of 72 at% of Dy, 26.2 at% of Fe and 1.8 at% of Co was first prepared as a raw material. A foamed sheet of an alloy of 93.6 at% of Fe and 6.4 at% of Co was next prepared. The foamed FeCo sheet was pressed so as to have a porosity of 43.1%. The thus-obtained foamed sheet was charged into a zironia mould of 4" φ in inner diameter and the master alloy was placed thereon. The mould was heated to 1,005°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Dy was 22.0 at%, Fe 73 at% and Co 5 at%. When evaluation was effected of the magnetic characteristic and the chemical composition distribution of the film on the substrate holder which has been formed by using a film forming apparatus and a film forming method similar to those in Example 4-1, the RE content was uniformly 21.5 to 22.0 at%, and the Hc was uniformly 13.5 to 13.0 KOe. Thus, a substantially uniform film was formed on the substrate holder. The amount of oxygen was as small as 430 ppm. When the target was used again after standing in the air for 24 hours, the sputtering discharge was stable from the beginning and the magnetic characteristic of the film was also stable from the beginning.

### Example 4-3

The effects of the present invention in relation to a target employing TbGdFeCo were examined. In the same way as in Examples 4-1 and 4-2, an ingot of a master alloy of 36 at% of Tb, 36 at% of Gd, 26.2 at% of Fe and 1.8 at% of Co was first prepared as a raw material. A foamed sheet of an alloy of 93.6 at% of Fe and 6.4 at% of CO was next prepared. The foamed FeCo sheet was pressed so as to have a porosity of 43.5%. The thus-obtained foamed sheet was charged into a mullite mould 4" φ in inner diameter and the master alloy was placed thereon. The mould was heated to 1,020°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the compositino of the target, Tb was 11 at%, Gd 11 at%, Fe 73 at% and Co 5 at%. When evaluation was effected of the magnetic characteristic and the chemical composition distribution of the film on the substrate holder which had been formed by using a film forming apparatus and a film forming method similar to those in Examples 4-1 and 4-2, the RE content was uniformly 21.5 to 22.0 at%, and the Hc was uniformly 14.5 to 15.0 KOe. Thus, a substantially uniform film was formed on the substrate holder. The amount of oxygen was as small as 480 ppm. When the target was used again after standing in the air for 24 hours, the sputtering discharge was stable from the beginning and the magnetic characteristic of the film was also stable from the beginning.

It was confirmed that the manufacture of the target of the present invention by the use of a foamed metal can be used with the same effects in relation to other compositions containing at least one heavy rare earth element selected from the group consisting of Gd, Tb and Dy and at least one transition metal selected from the group consisting of Fe and Co, such as TbFe, TbCo, GdFeCo, GdDyFeCo, GdDyTbFeCo, GdTbFe, DyCo, TbGdCo and TbDyCo as well as the compositions shown in Examples 4-1, 4-2 and 4-3.

It was also confirmed that it is possible to have a desired Co composition by adjusting the Co content in the master alloy while using Fe as the foamed transition metal sheet.

An embodiment of the present invention in which a target containing a light rare earth metal is employed, namely, a target consisting of a light rare earth metal, a heavy rare earth metal and a transition metal, by the method comprising the use of a foamed metal will now be explained.

### Example 4-4

The effects of the present invention in relation to a target employing NdDyFeCo were examined. In the same way as in Examples 4-1,4-2, etc., an ingot of a master alloy of 78.2 at% of (Nd_{0.2}Dy_{0.8}) and 27.8 at% of (Fe_{0.8}Co_{0.2}) was first prepared as a raw material. A foamed sheet of an alloy of 80 at% of Fe and 20 at% of Co was next prepared. The foamed FeCo sheet was pressed so as to have a porosity of 62.6%. The thus-obtained foamed sheet was charged into an isolite mould of 4" φ in inner diameter and the master alloy was placed thereon. The mould was heated to 1,030°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Nd was 5.5 at%, Dy 22.0 at%, Fe 58.0 at% and Co 14/5 at%. When evaluation was effected of the magnetic characteristic and the chemical composition distribution of the film on the substrate holder which had been formed by using a film forming apparatus and a film forming method similar to those in Examples 4-1, 4-2, etc., the RE content was uniformly 28.0 to 28.3 at%, and the Hc was uniformly 9.7 to 10.5 KOe. Thus a substantially uniform film was formed on the substrate holder. The amount of oxygen was as small as 475 ppm. When the target was used again after standing in the air for 24 hours, the sputtering discharge was stable from the beginning and the magnetic characteristic of the film was also stable from the beginning.

### Example 4-5

The effects of the present invention in relation to a target employing PrTbDyFeCo were examined. In the same way as in Examples 4-1, 4-2 etc., an ingot of a master alloy of 80 at% of(Pr_{0.2}Tb_{0.4}Dy_{0.4}) and 20 at% of (Fe_{0.8}Co_{0.2}) was first prepared as a raw material. The melting point of the master alloy was about 820°C. A foamed sheet of an alloy of 80 at% of Fe and 20 at% of Co was next prepared. The foamed FeCo sheet was pressed so as to have a porosity of 62.8%. The thus-obtained foamed sheet was charged into an alumina mould of 4" φ in inner diameter and the master alloy was placed thereon. The mould was heated to 1,030°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the composition of the target, Pr was 5.5 at%, TB 11 at%, Dy 11 at%, Fe 58 at% and Co 14.5 at%. When evaluation was effected of the magnetic characteristic and the composition distribution of the film on the substrate holder which had been formed by using a film forming apparatus and a film forming method similar to those in Examples 4-1, 4-2 etc., the RE content was uniformly 28.0 to 27.8 at%, and the Hc was uniformly 15.5 to 15.8 KOe. Thus, a substantially uniform film was formed on the substrate holder. The amount of oxygen was as small as 475 ppm. Even when the target was used again after standing in the air for 24 hours, the sputtering discharge was stable from the beginning and the magnetic characteristic of the film was also stable from the beginning.

### Example 4-6

The effects of the present invention in relation to a target employing PrSmDyGdFeCo were examined. In the same way as in Examples 4-1, 4-2 etc., an ingot of a master alloy of 72.2 at% of (Pr_{0.1}Sm_{0.1}Dy_{0.4}Gd_{0.4}) and 27.8 at% of (Fe_{0.8}Co_{0.2}) was first prepared as a raw material. The melting point of the master alloy was about 880°C. A foamed sheet of an alloy of 80 at% of Fe and 20 at% of Co was next prepared. The foamed FeCo sheet was pressed so as to have a porosity of 63.1%. The thus obtained foamed sheet was charged into an alumina mould of 4" φ in inner diameter and the master alloy was placed thereon. The mould was heated to 1,040°C in vacuo in the non-pressurized state. After the master alloy was melted, the mould was cooled. The moulded product removed from the mould was machined and ground so as to produce a sputtering target of 4" φ x 3t. The surface structure of the thus-obtained target was composed of three phases consisting of an RE phase, an RE-TM alloy phase and a TM phase. In the case of the chemical composition of the target, Pr was 2.75 at%, Sm 2.75 at%, Dy 11 at%, Gd 11 at%, Fe 58 at% and Co 14.5 at%. When evaluation was effected of the magnetic characteristic and the chemical composition distribution of the film on the substrate holder which had been formed by using a film forming apparatus and a film forming method similar to those in Examples 4-1, 4-2 etc., the RE content was uniformly 28.0 to 28.1 at% and the Hc was uniformly 7.2 to 7.5 KOe. Thus, a substantially uniform film was formed on the substrate holder. The amount of oxygen was as small as 490 ppm. When the target was used again after standing in the air for 24 hours, the sputtering discharge was stable from the beginning and the magnetic characteristic of the film was also stable from the beginning.

It was confirmed that the foamed method of producing a target according to the present invention can be used with the same effects in relation to compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as NdGdFeCo, NdTbFeCo, NdPrDyTbFeCo, PrDyFeCo, NdSmGdFeCo, PrTbFeCo, CeNdDyFeCo and CeNdPrDyFeCo as well as the compositions shown in Examples 4-4, 4-5 and 4-6.

It was also confirmed that it is possible to have a desired Co composition by adjusting the Co content in the master alloy while using Fe as the foamed transition metal sheet.

The porosity of a powder or a foamed sheet is important in an impregnation method, which is one of the methods which can be used of making a target according to the present invention. This is because a molten ingot infiltrates into the pores of a powder or a foamed sheet when a target is manufactured and the composition of the target is determined by the porosity. In other words, a target of a desired composition is provided by controlling the porosity.

Since a recording medium should desirably have 15 to 35 at% of a rare earth metal, the composition of a target according to the present invention may be determined so as to satisfy this condition. The composition of the target may be so controlled as to satisfy this condition by varying the porosity of a powder or of a foamed sheet.

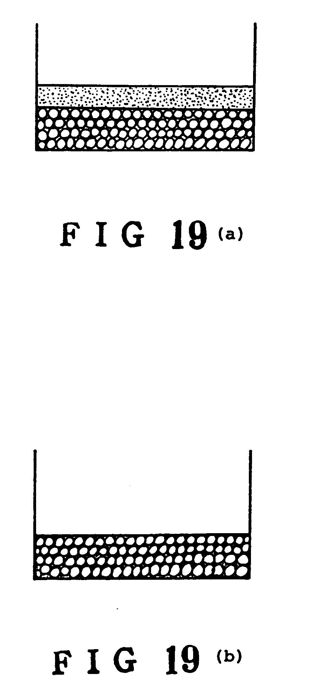

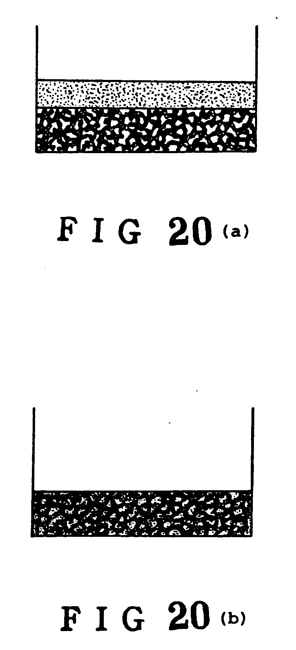

To state this more concretely, a powder having a porosity of about 30% is first prepared, and an ingot is placed thereon, as shown in Figure 19(a). The ingot is melted to permeate the powder, as shown in Figure 19(b). It is clear from Figure 19(b) that the molten ingot infiltrates only into the pores of the powder. A powder having a porosity of about 80% is next prepared, and an ingot is placed thereon, as shown in Figure 20(a). Similarly, the ingot is melted to permeate the powder, as shown in Figure 20(b). In this way, it is possible to control the porosity of a powder or of a foamed sheet, thereby determining the composition of the target.

### Example 5-1

Powders and foamed sheets of a TM having various porosities were prepared to produce sputtering targets of NdDyFeCo by an impregnation method.

An ingot of an alloy of 72.2 at% of (Nd_{0.2}Dy_{0.8}) and 27.8 at% of (Fe_{0.8}Co_{0.2}) was first prepared. Powders of an alloy of 80 at% of Fe and 20 at% of Co having a particle diameter of 200 µm and porosities of 30%, 40%, 50%, 62%, 70% and 80%, respectively, were next prepared. It is possible to control the porosity of the powders by preparing powders having particles of various shapes from a spherical shape to irregular shapes. Similarly, foamed sheets of an alloy of 80 at% of Fe and 20 at% of Co having porosities of 30%, 40%, 50%, 62%, 70% and 80%, respectively, were prepared. It is possible to control the porosity of the sheets by pressing. Sputtering targets were manufactured by using these FeCo powders and foamed FeCo sheets having different porosities by the same method as in Examples 3-1 and 4-4. Tables 3 and 4 show the porosities of the powders and foamed sheets used and the compositions of the targets produced, respectively.

**Table 3**

| Porosity of FeCo powder (%) | Target composition (at%) |
|---|---|
| 30 | Nd_{2.7}Dy_{11.6}Fe_{68.3}Co_{17.4} |
| 40 | Nd_{3.6}Dy_{14.2}Fe_{65.8}Co_{16.4} |
| 50 | Nd_{4.4}Dy_{17.6}Fe_{62.4}Co_{15.6} |
| 62 | Nd_{5.5}Dy_{22.6}Fe_{58.0}Co_{14.5} |
| 70 | Nd_{6.2}Dy_{24.7}Fe_{55.3}Co_{13.8} |
| 80 | Nd_{7.1}Dy_{28.3}Fe_{51.8}Co_{12.8} |

**Table 4**

| Porosity of foamed FeCo sheet (%) | Target composition (at%) |
|---|---|
| 30 | Nd_{2.7}Dy_{11.6}Fe_{68.3}Co_{17.4} |
| 40 | Nd_{3.6}Dy_{14.2}Fe_{65.8}Co_{16.4} |
| 50 | Nd_{4.4}Dy_{17.6}Fe_{62.4}Co_{15.6} |
| 62 | Nd_{5.5}Dy_{22.6}Fe_{58.0}Co_{14.5} |
| 70 | Nd_{6.2}Dy_{24.7}Fe_{55.3}Co_{13.8} |
| 80 | Nd_{7.1}Dy_{28.3}Fe_{51.8}Co_{12.8} |

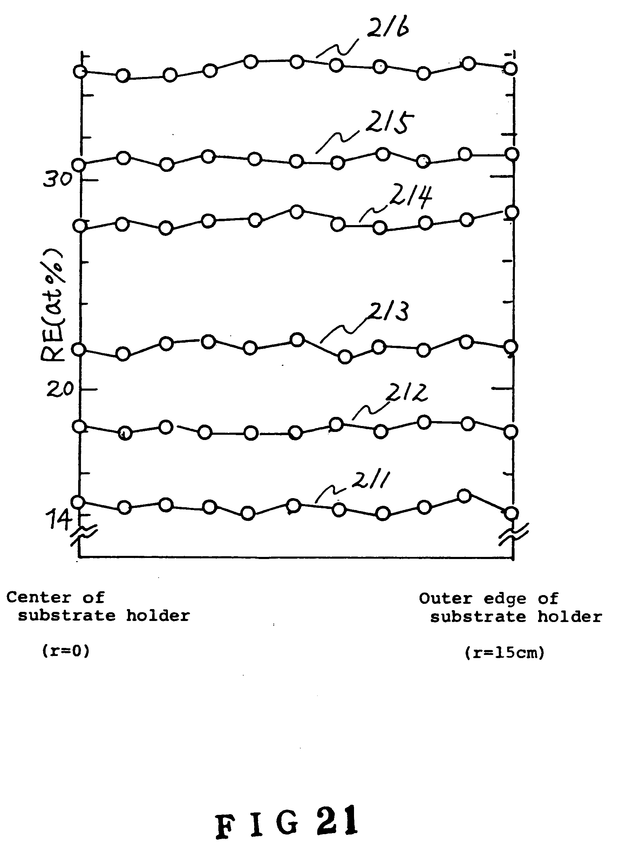

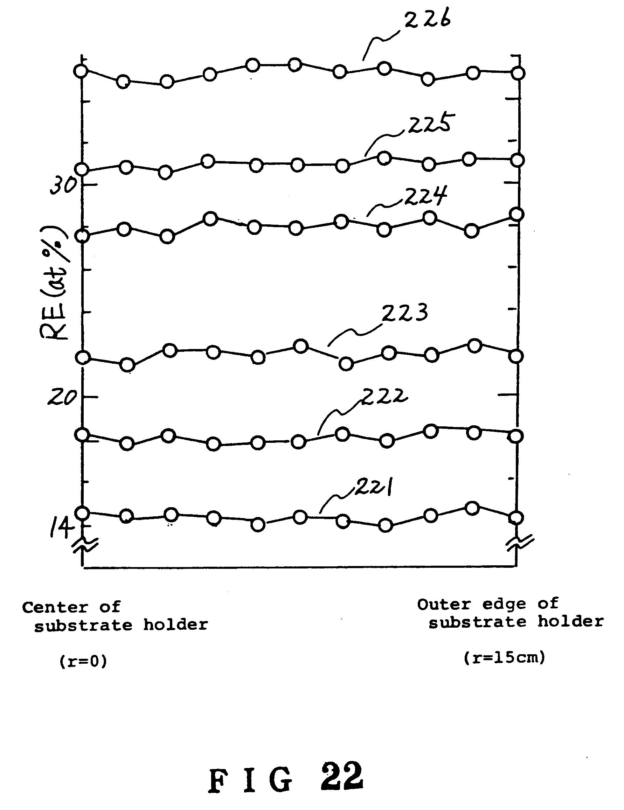

Films were formed by using these targets obtained by varying the porosities of FeCo powders or foamed FeCo sheets and by means of a sputtering device similar to that shown in Figure 2, and the chemical composition distributions on the substrate holder were examined. Figure 21 shows the chemical composition distributions of the films formed by using the targets obtained from powders having various porosities, and Figure 22 shows the chemical composition distributions of the films formed by using the targets obtained from foamed sheets having various porosities.

Curves 211 to 216 show the chemical composition distributions of the films formed by using the targets obtained from powders having porosities of 30%, 40%, 50%, 62%, 70% and 80%, respectively. Curves 221 to 226 show the chemical composition distributions of the films formed by using the targets obtained from foamed sheets having porosities of 30%, 40%, 50%, 62%, 70% and 80%, respectively. Whichever method of manufacture of the target is used, the film shows a very small chemical composition distribution and a very good uniformity. It is possible to vary the film composition by controlling the porosity of a powder or of a foamed sheet.

It was confirmed that this method can be used in relation to targets which contain at least one light rare earth metal selected from the group consisting of Sm, Nd, Pr and Ce, at least one heavy rare earth metal selected from the group consisting of Gd, Tb and Dy and at least one transition metal selected from the group consisting of Fe and Co such as PrTbFeCo, SmGdFeCo, SmDyTbFeCo, NdTbFeCo, NdPrDyFeCo, NdPrDyTbFeCo, PrDyFeCo, NdSmGdTbFeCo, CeNdFeCo and CeNdPrDyFeCo.

### Example 5-2

Powders and foamed sheets of a TM having various porosities were prepared to produce sputtering targets of TbFeCo by an impregnation method.

An ingot of an alloy of 72 at% of Tb and 28 at% of (Fe_{0.9}Co_{0.1}) was first prepared. Powders of an alloy of 90 at% of Fe and 10 at% of Co having a particle diameter of 200 µm and porosities of 30%, 43%, 50%, 62%, 70% and 80%, respectively, were next prepared. It is possible to control the porosity of the powders by preparing powders having particles of various shapes from a spherical shape to irregular shapes. Similarly, foamed sheets of an alloy of 90 at% of Fe and 10 at% of CO having porosities of 30%, 43%, 50%, 62%, 70% and 80%, respectively, were prepared. It is possible to control the porosity of the sheets by pressing. Sputtering targets were manufactured by using these FeCo powders and foamed FeCo sheets having different porosities by the same method as in Examples 3-5 and 4-1. Tables 5 and 6 show the porosities of the powders and foamed sheets used and the compositions of the targets produced, respectively.

**Table 5**

| Porosity of FeCo powder (%) | Target composition (at%) |
|---|---|
| 30 | Tb_{15.6}Fe_{76.5}Co_{8.5} |
| 43 | Tb₂₂Fe_{70.2}Co_{7.8} |
| 50 | Tb_{25.5}Fe_{67.0}Co_{7.5} |
| 60 | Tb_{30.5}Fe_{62.6}Co_{6.9} |
| 70 | Tb_{35.5}Fe_{58.5}Co_{6.5} |
| 80 | Tb_{40.7}Fe_{53.4}Co_{5.9} |

**Table 6**

| Porosity of foamed FeCo sheet (%) | Target composition (at%) |
|---|---|
| 30 | Tb_{15.6}Fe_{76.5}Co_{8.5} |
| 43 | Tb₂₂Fe_{70.2}Co_{7.8} |
| 50 | Tb_{25.5}Fe_{67.0}Co_{7.5} |
| 60 | Tb_{30.5}Fe_{62.6}Co_{6.9} |
| 70 | Tb_{35.5}Fe_{58.5}Co_{6.5} |
| 80 | Tb_{40.7}Fe_{53.4}Co_{5.9} |

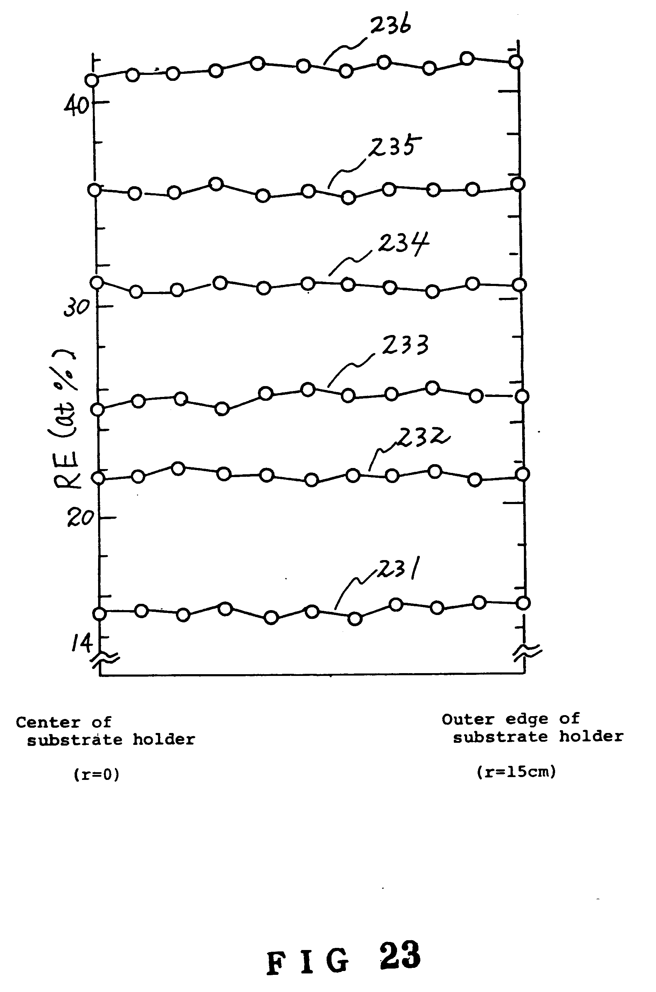

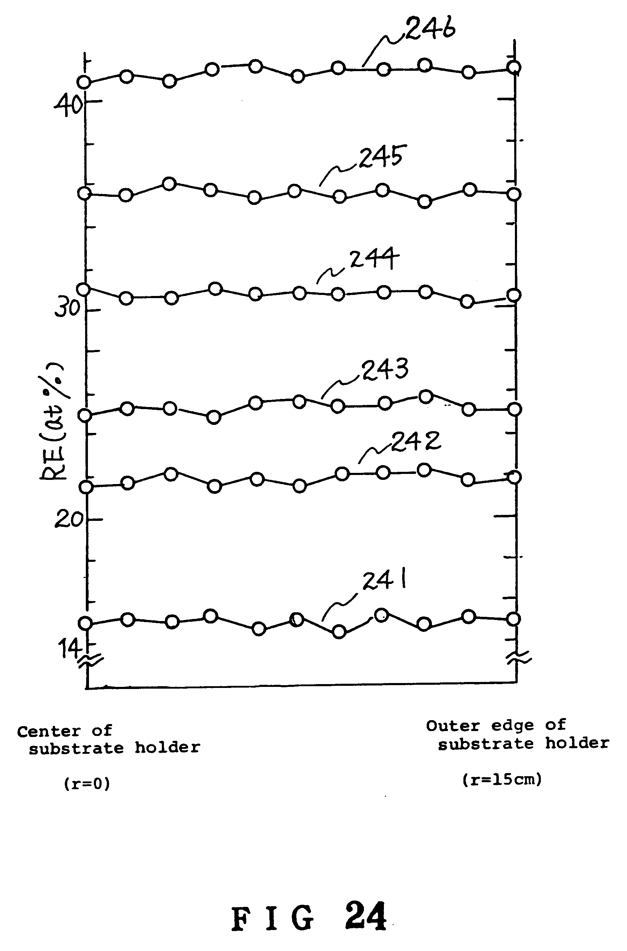

Films were formed by using these targets obtained by varying the porosities of FeCo powders or foamed FeCo sheets and by using a sputtering device similar to that shown in Figure 2, and the chemical composition distributions in the substrate holder were examined Figure 23 shows the chemical composition distributions of the films formed by using the targets so obtained by using powders having various porosities and Figure 24 shows the chemical composition distributions of the films formed by using the targets obtained by using foamed sheets having various porosities.

Curves 231 to 236 show the chemical composition distributions of the films formed by using the targets obtained by the use of powders having porosities of 30%, 43%, 50%, 60%, 70% and 80%, respectively. Curves 241 to 246 show the composition distributions of the films formed by using the targets obtained by the use of foamed sheets having porosities of 30%, 43%, 50%, 60%, 70% and 80%, respectively. Whichever method of manufacture of the target is used, the film shows a very small chemical composition distribution and a very good uniformity. It is possible to vary the film composition by controlling the porosity of a powder or a foamed sheet.

It was confirmed that this method can be used in relation to other composition systems which contain at least one heavy rare earth metal selected from the group consisting of Gd, Tb and Dy and at least one transition metal selected from the group consisting of Fe and Co such as DyFeCo, TbGdFeCo, TbFe, GdFeCo, GdDyFeCo, GdDyTbFeCo, GdTbFeCo, TbCo, GdTbFe and TbDyCo.

Targets were manufactured from various powders of a transition metal having different particle diameters.

### Example 6-1

The manufacturing method employed is substantially the same as in Example 3-1.

An ingot (4" φ 4t) of a master alloy of 72.2 at% of (Nd_{0.2}Dy_{0.8}) and 27.8 at% of (Fe_{0.8}Co_{0.2}) was first prepared as a raw material. Various powders of an alloy of 80 at% of Fe and 20 at% of Co having different particle diameters were next prepared. The master alloy was placed on each of these powders and heated to 1,000°C in vacuo to produce a sputtering target of 4" φ x 6t.

The average particle diameters of the powders used were 5 µm, 8 µm, 10 µm, 24 µm, 38 µm, 53 µm, 120 µm, 230 µm, 570 µm, 730 µm, 1 mm, 1.5 mm, 2 mm, 3 mm, 3.2 mm and 4 mm.

Table 7 shows the finished state of the target for each powder used.

**Table 7**

| Average particle diameter and porosity of FeCo powder | Finished state of target |
|---|---|
| 5 µm, 64% | Infiltrated to 3% of the height of the powder from the top |
| 8 µm, 64% | Infiltrated to 5% of the height of the powder from the top |
| 10 µm, 64% | Infiltrated to 100% of the height of the powder from the top |
| 24 µm, 62% | 100% impregnation |
| 38 µm, 58% | 100% impregnation |
| 53 µm, 55% | 100% impregnation |
| 120 µm, 51% | 100% impregnation |
| 230 µm, 48% | 100% impregnation |
| 570 µm, 44% | 100% impregnation |
| 730 µm, 64% | 100% impregnation |
| 1.0 mm, 62% | 100% impregnation |
| 1.5 mm, 58% | 100% impregnation |
| 2.5 mm, 55% | 100% impregnation |
| 3.0 mm, 53% | 100% impregnation |
| 3.2 mm, 51% | 100% impregnation |
| 4.0 mm, 48% | 100% impregnation |

From Table 7, it is clear that when powders having average particle diameters of 5 µm and 8 µm are used, the master alloy does not infiltrate, thereby making the manufacture of a target impossible. This is because the particle diameter and the pore of such a powder are so small that the molten metal of the master alloy, which has a predetermined viscosity, cannot permeate the powder. Powders having an average particle diameter of not less than 10 µm can, however, produce a target of 100% impregnation.

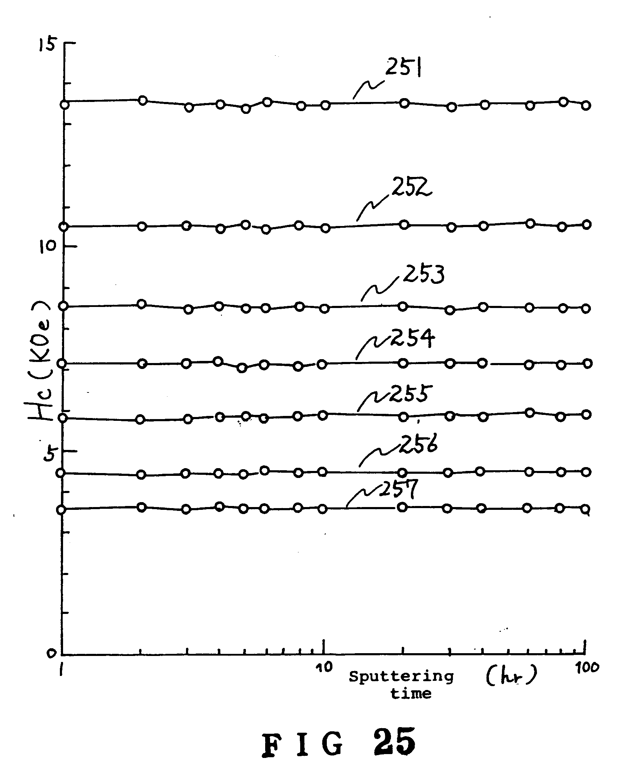

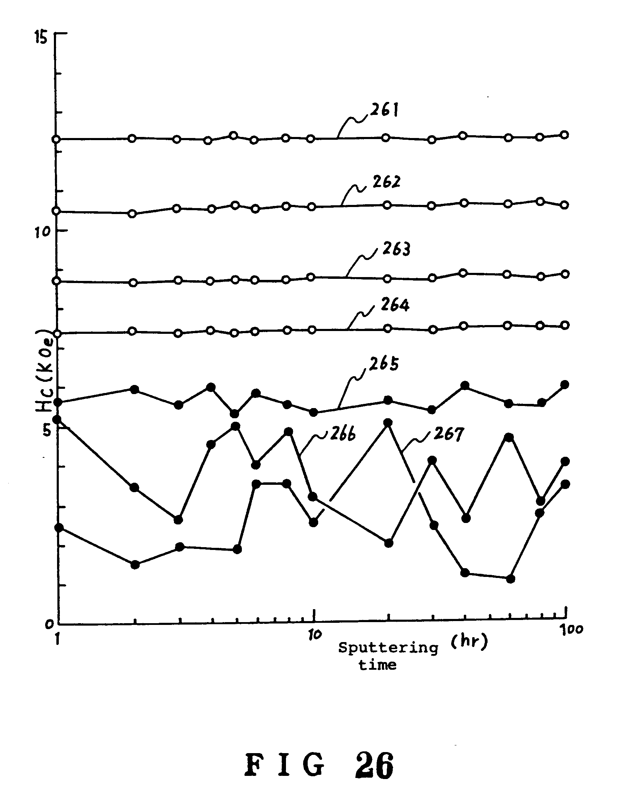

Targets obtained by using powders having a particle diameter of not less than 10 µm were mounted on the sputtering device shown in Figure 2 for film formation. In the case of each of such targets, discharge was stable from the beginning without any problem. Each target was subjected to sputtering for a long time to examine the relationship between the sputtering time and the magnetic characteristic of the film. The results are shown in Figures 25 and 26.

In Figure 25, the reference numerals 251 to 257 denote targets obtained by using powders having particle diameters of 10 µm, 24 µm, 38 µm, 53 µm, 120 µm, 230 µm and 570 µm, respectively. It was confirmed that films formed by using the targets obtained from powders having particle diameters of 10 µm to 570 µm had a constant magnetic characteristic at any sputtering time and were adequately usable. It is because the difference in the porosity among the powders makes the compositions of the targets different that the magnetic characteristics of the films are different, and this has no direct relationship with the present invention.

In Figure 26, the reference numerals 261 to 267 denote targets obtained by using powders having particle diameters of 730 µm, 1.0 mm, 1.5 mm, 2.5 mm, 3.0 mm, 3.2 mm and 4.0 mm,respectively. It was confirmed that the films formed by using the targets obtained from powders having particle diameters of 730 µm to 2.5 mm had a constant magnetic characteristic at any sputtering time and were adequately usable. In the film formed by using the target 265 obtained by using a powder having a particle diameter of 3.0 mm, the magnetic characteristic slightly fluctuates depending on the sputtering time. This is because the large particle size causes some variation in the ratio of the RE, RE-TM and TM on the surface of the target in dependence upon the sputtering time. The target 265 obtained by using the powder having a particle diameter of about 3.0 mm is usable because the range of variation of the magnetic characteristic of the film obtained is not very large. However, in the targets 266 and 267 obtained by using the powders having particle diameters of 3.2 mm and 4.0 mm, the variation of the magnetic characteristics of the films obtained is so large that these targets 266 and 267 are not usable. Accordingly, the average particle diameter of a TM powder used for manufacturing a target of the present invention should be 10 µm to 3.0 mm.

It was confirmed that it is necessary to use a TM powder having a particle diameter of 10 µm to 3 mm in other compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as PrTbFeCo, SmGdFeCo, SmGdTbFeCo, NdTbFeCo, NdGdFeCo, NdPrDyFeCo, NdPrDyTbFeCo, PrDyFeCo, NdSmGdTbFeCo, CeNdDyFeCo and CeNdprDyFeCo.

### Example 6-2

TbFeCo targets were manufactured by using various powders of a transition metal having different particle diameters by the same method as in Example 3-5.

An ingot (4" φ x 4t) of a master alloy of 72 at% of Tb and 28 at% of (Fe_{0.9}Co_{0.1}) was first prepared as a raw material. Various powders of an alloy of 90 at% of Fe and 10 at% of Co having different particle diameters were next prepared. The master alloy was placed on each of these powders and heated to 1,010°C in vacuo to produce a sputtering target of 4" φ x 6t.

The average particle diameters of the powders used were 5 µm, 8 µm, 10 µm, 24 µm, 38 µm, 53 µm, 120 µm, 230 µm, 570 µm, 730 µm, 1 mm, 1.5 mm, 2 mm, 3 mm, 3.2 mm and 4 mm.

Table 8 shows the finished state of the target for each powder used.

**Table 8**

| Average particle diameter and porosity of FeCo powder | Finished state of target |
|---|---|
| 5 µm, 44% | Infiltrated to 3% of the height of the powder from the top |
| 8 µm, 44% | Infiltrated to 5% of the height of the powder from the top |
| 10 µm, 44% | Infiltrated to 100% of the height of the powder from the top |
| 24 µm, 42% | 100% impregnation |
| 38 µm, 39% | 100% impregnation |
| 53 µm, 37% | 100% impregnation |
| 120 µm, 35% | 100% impregnation |
| 230 µm, 32% | 100% impregnation |
| 570 µm, 30% | 100% impregnation |
| 730 µm, 44% | 100% impregnation |
| 1.0 mm, 42% | 100% impregnation |
| 1.5 mm, 39% | 100% impregnation |
| 2.5 mm, 37% | 100% impregnation |
| 3.0 mm, 35% | 100% impregnation |
| 3.2 mm, 32% | 100% impregnation |
| 4.0 mm, 30% | 100% impregnation |

From Table 8, it is clear that when powders having average particle diameters of 5 µm and 8 µm are used, the master alloy does not infiltrate, thereby making the manufacture of a target impossible. This is because the particle diameter and the pore of such a powder are so small that the molten metal of the master alloy, which has a predetermined viscosity, cannot permeate the powder. Powders having an average particle diameter of not less than 10 µm can, however, produce a target of 100% impregnation.

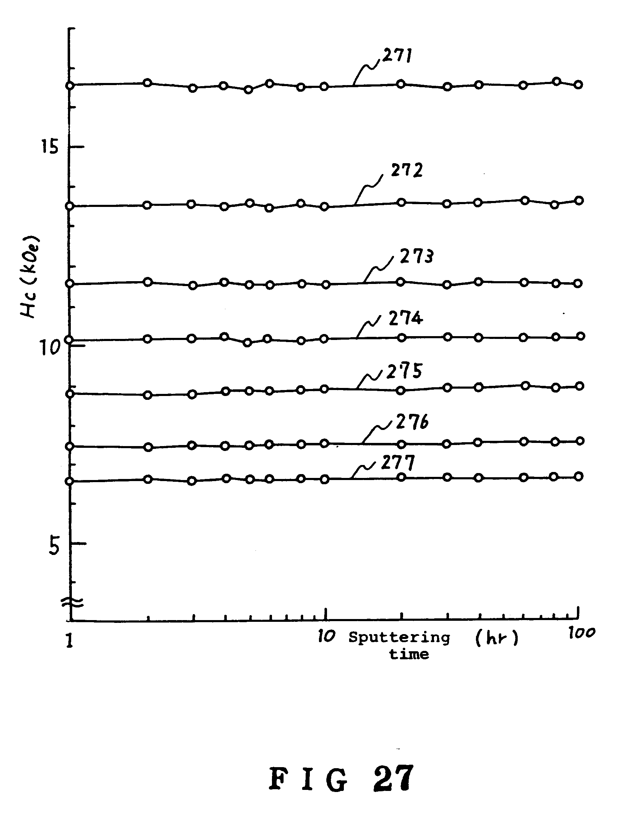

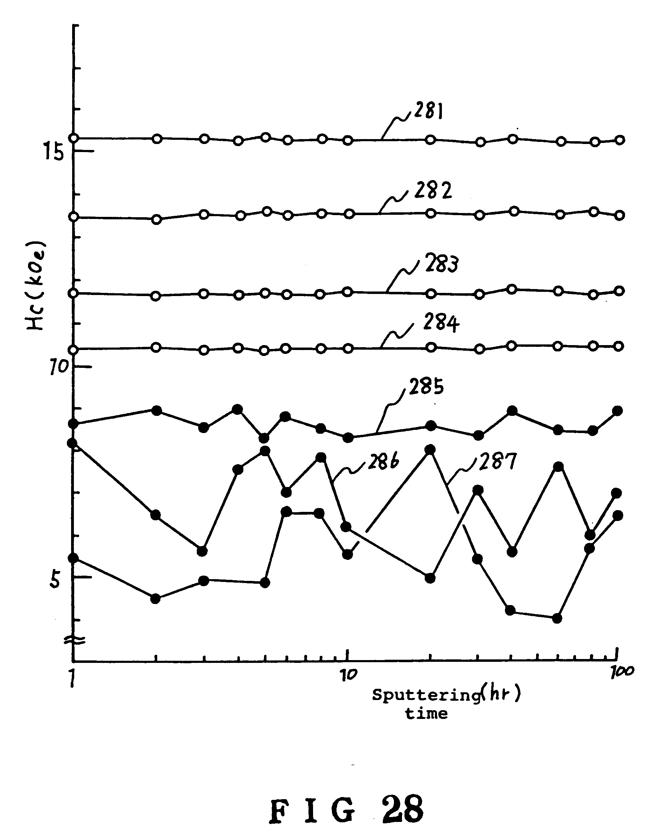

The targets obtained by using powders having a particle diameter of not less than 10 µm were mounted on the sputtering device shown in Figure 2 for film formation. In the case of each of these targets, discharge was stable from the beginning and there was no problem. Each target was subjected to sputtering for a long time to examine the relationship between the sputtering time and the magnetic characteristic of the film. The results are shown in Figures 27 and 28.

In Figure 27, the reference numerals 271 to 277 denote targets obtained by using powders having particle diameters of 10 µm, 24 µm, 38 µm, 53 µm, 120 µm, 230 µm and 570 µm, respectively. It was confirmed that the films formed by using the targets obtained from powders having particle diameters of 10 µm to 570 µm had a constant magnetic characteristic at any sputtering time and were adequately usable. It is because the difference in the porosity among the powders makes the compositions of the targets different that the magnetic characteristics of the films are different, and this has no direct relationship with the present invention.

In Figure 28, the reference numerals 281 to 287 denote targets obtained by using powders having particle diameters of 730 µm, 1.0 mm, 1.5 mm, 2.5 mm, 3.0 mm, 3.2 mm and 4.0 mm, respectively. It was confirmed that films formed by using the targets obtained from powders having particle diameters of 730 µm to 2.5 mm had a constant magnetic characteristic at any sputtering time and were adequately usable. In the film formed by using the target 285 obtained from a powder having a particle diameters of 3.0 mm, the magnetic characteristic varies slightly depending on the sputtering time. This is because the large particle size causes a variation in the ratio of the RE, RE-TM and TM on the surface of the target depending upon the sputtering time. The target 285 obtained by using powder having a particle diameter of about 3.0 mm is usable because the amount of variation of the magnetic characteristic of the film obtained is not so large. However, in the case of the targets 286 and 287 obtained from powders having particle diameters of 3.2 mm and 4.0 mm, the variation of the magnetic characteristics of the films obtained is so great that these targets 286 and 287 are not usable. Accordingly, the average particle diameter of a TM powder used for manufacturing a target of the present invention should be 10 µm to 3.0 mm.

It was confirmed that it is necessary to use a TM powder having a particle diameter of 10 µm to 3 mm in other compositions containing at least one heavy rare earth element selected from the group consisting of Gd, Tb and Dy and at least one transition metal selected from the group consisting of Fe and Co, such as DyFeCo, TbGdFeCo, TbFe, GdFeCo, GdDyFeCo, GdDyTbFeCo, DyTbFeCo, TbCo, GdTbFe and TbDyCo.

Targets were manufactured by using various foamed sheets of a transition metal having different pore diameters.

### Example 7-1

NdDyFeCo targets were manufactured from various foamed sheets of a transition metal having different pore diameters by the same method as in Example 4-4.

An ingot (4" φ x 4t) of a master alloy of 72.2 at% of (Nd_{0.2}Dy_{0.8}) and 27.8 at% of (Fe_{0.8}Co_{0.2}) was first prepared as a raw material. Various foamed sheets of an alloy of 80 at% of Fe and 20 at% of Co having different pore diameters were next prepared. The master alloy was placed on each of these foamed sheets and heated to 1,000°C in vacuo to produce a sputtering target of 4" φ x 6t.

The average pore diameters of the foamed sheets used were 5 µm, 8 µm, 10 µm, 24 µm, 38 µm, 53 µm, 120 µm, 230 µm, 570 µm, 730 µm, 1mm, 1.5 mm, 2 mm, 3 mm, 3.2 mm and 4 mm.

Table 9 shows the finished state of the target for each foamed metal sheet used.

**Table 9**

| Average particle diameter and porosity of foamed FeCo sheet | Finished state of target |
|---|---|
| 5 µm, 64% | Infiltrated to 3% of the height of the foamed FeCo sheet from the top |
| 8 µm, 64% | Infiltrated to 5% of the height of the foamed FeCo sheet from the top |
| 10 µm, 64% | Infiltrated to 100% of the height of the the foamed FeCo sheet from the top |
| 24 µm, 62% | 100% impregnation |
| 38 µm, 58% | 100% impregnation |
| 53 µm, 55% | 100% impregnation |
| 120 µm, 51% | 100% impregnation |
| 230 µm, 48% | 100% impregnation |
| 570 µm, 44% | 100% impregnation |
| 730 µm, 64% | 100% impregnation |
| 1.0 mm, 62% | 100% impregnation |
| 1.5 mm, 58% | 100% impregnation |
| 2.5 mm, 55% | 100% impregnation |
| 3.0 mm, 53% | 100% impregnation |
| 3.2 mm, 51% | 100% impregnation |
| 4.0 mm, 48% | 100% impregnation |

From Table 9, it is clear that when foamed sheets having average pore diameters of 5 µm and 8 µm are used, the master alloy does not infilitrate, thereby making the manufacture of a target impossible. This is because the pore diameter of such a foamed sheet is so small that the molten metal of the master alloy, which has a predetermined viscosity,cannot permeate the sheet. Foamed sheets having an average pore diameter of not less than 10 µm can produce a target of 100% impregnation.

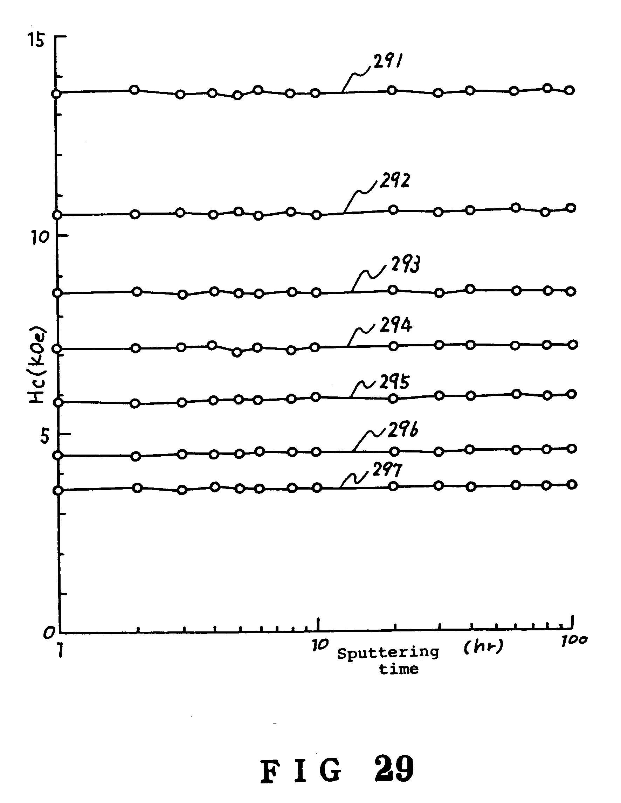

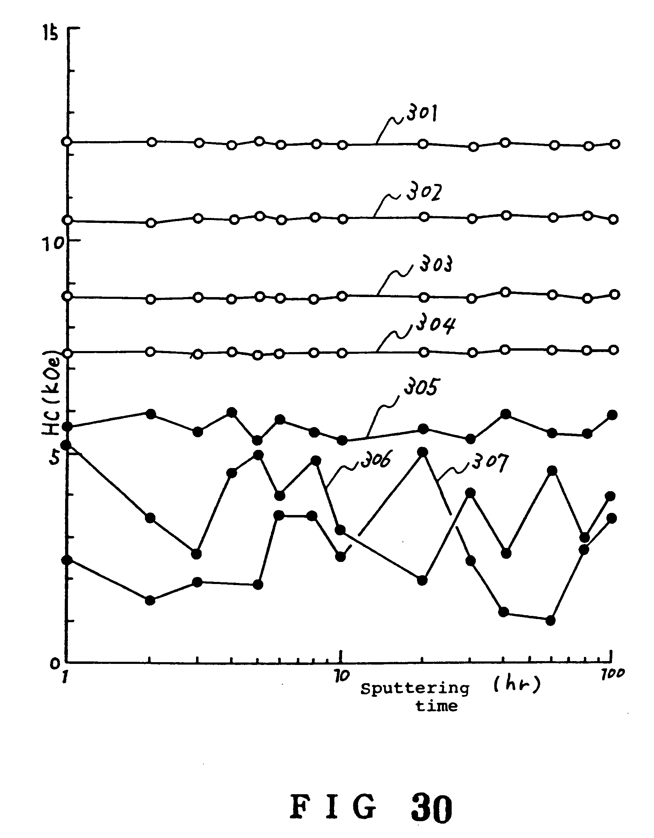

The targets obtained by using foamed sheets having a pore diameter of not less than 10 µm were mounted on the sputtering device shown in Figure 2 for film formation. In the case of each of these targets, discharge was stable from the beginning and there was no problem. Each target was subjected to sputtering for a long time to examine the relationship between the sputtering time and the magnetic characteristic of the film. The results are shown in Figures 29 and 30.

In Figure 29, the reference numerals 291 to 297 denote targets obtained by sing foamed sheets having pore diameters of 10 µm, 24 µm, 38 µm, 53 µm, 120 µm, 230 µm and 570 µm, respectively. It was confirmed that films formed by using the targets obtained from the foamed sheets having pore diameters of 10 µm to 570 µm had a constant magnetic characteristic at any sputtering time and were adequately usable. It is because the difference in the porosity among the foamed sheets makes the compositions of the targets different that the magnetic characteristics of the films are different, and this has no direct relationship with the present invention.

In Figure 30, the reference numerals 301 to 307 denote targets obtained by using foamed sheets having pore diameters of 730 µm, 1.0 mm, 1.5 mm, 2.5 mm, 3.0 mm, 3.2 mm and 4.0 mm, respectively. It was confirmed that the films formed by using the targets obtained from foamed sheets having pore diameters of 730 µm to 2.5 mm had a constant magnetic characteristic at any sputtering time and were adequately usable. In the film formed by using the target 305 obtained from a foamed sheet having a pore diameter of 3.0 mm, the magnetic characteristic slightly varies depending on the sputtering time. This is because the large pore size causes a variation in the ratio of the RE, RE-TM and TM on the surface of the target depending upon the sputtering time. The target 305 obtained from a foamed sheet having a pore diameter of about 3.0 mm is usable because the variation of the magnetic characteristic of the film obtained is not so large. However, in the targets 306 and 307 obtained by using a foamed sheet having pore diameters of 3.2 mm and 4.0 mm, the variation of the magnetic characteristics of the films obtained are so large that these targets 306 and 307 are not usable. Accordingly, the average pore diameter of a foamed TM sheet used for manufacturing a target of the present invention should be 10 µm to 3.0 mm.

It was confirmed that it is necessary to use a TM foamed sheet having a pore diameter of 10 µm to 3 mm in other compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as PrTbFeCo, SmGdFeCo, SmGdTbFeCo, NdTbFeCo, NdGdFeCo, NdPrDyFeCo, NdPrDyTbFeCo, PrDyFeCo, NdSmGdTbFeCo, CeNdDyFeCo and CeNdPrDyFeCo.

### Example 7-2

TbFeCo targets were manufactured by using various foamed sheets of a transition metal having different pore diameters by the same method as in Example 4-1.

An ingot (4" φ x 4t) of a master alloy of 72 at% of Tb and 28 at% of (Fe_{0.9}Co_{0.1}) was first prepared as a raw material. Various foamed sheets of an alloy of 90 at% of Fe and 10 at% of Co having different pore diameters were next prepared. The master alloy was placed on each of these foamed sheets and heated to 1,010°C in vacuo to produce a sputtering target of 4" φ x 6t.

The average pore diameters of the foamed sheets used were 5 µm, 8µm, 10 µm, 24 µm, 38 µm, 53 µm, 120 µm, 230 µm, 570 µm, 730 µm, 1 mm, 1.5 mm, 2 mm, 3 mm, 3.2 mm and 4 mm.

Table 10 shows the finished state of the target for each foamed metal sheet used.

**Table 10**

| Average pore diameter and porosity of foamed FeCo sheet | Finished state of target |
|---|---|
| 5 µm, 44% | Infiltrated to 3% of the height of the foamed FeCo sheet from the top |
| 8 µm, 44% | Infiltrated to 5% of the height of the foamed FeCo sheet from the top |
| 10 µm, 44% | Infiltrated to 100% of the height of the foamed FeCo sheet from the top |
| 24 µm, 42% | 100% impregnation |
| 38 µm, 39% | 100% impregnation |
| 53 µm, 37% | 100% impregnation |
| 120 µm, 35% | 100% impregnation |
| 230 µm, 32% | 100% impregnation |
| 570 µm, 30% | 100% impregnation |
| 730 µm, 44% | 100% impregnation |
| 1.0 mm, 42% | 100% impregnation |
| 1.5 mm, 39% | 100% impregnation |
| 2.5 mm, 37% | 100% impregnation |
| 3.0 mm, 35% | 100% impregnation |
| 3.2 mm, 32% | 100% impregnation |
| 4.0 mm, 30% | 100% impregnation |

From Table 9, it is clear that when foamed sheets having average pore diameters of 5 µm and 8 µm are used, the master alloy does not infiltrate, thereby making the manufacture of a target impossible. This is because the pore diameter of such a foamed sheet is so small that the molten metal of the master alloy, which has a predetermined viscosity, cannot permeate the sheet. Foamed sheets having an average pore diameter of not less than 10 µm, however, can produce a target of 100% impregnation.

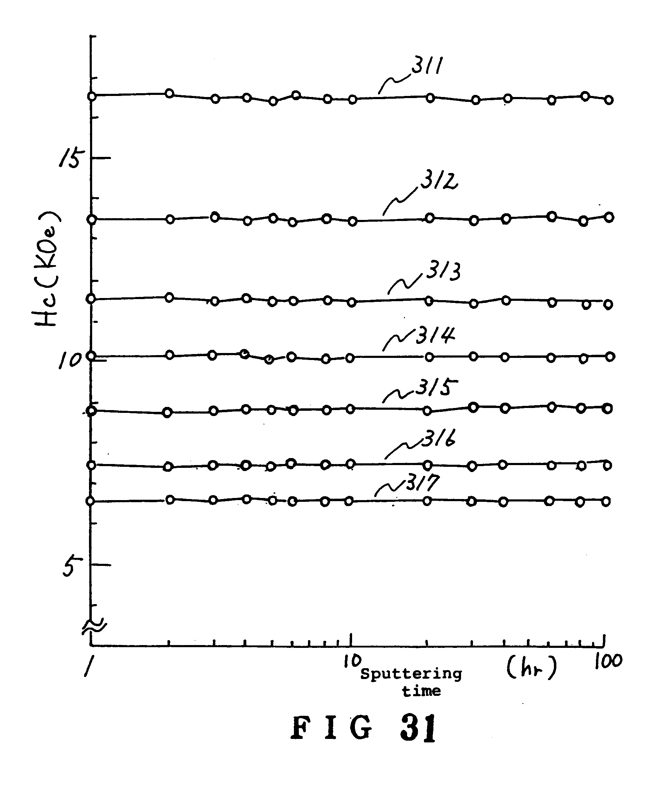

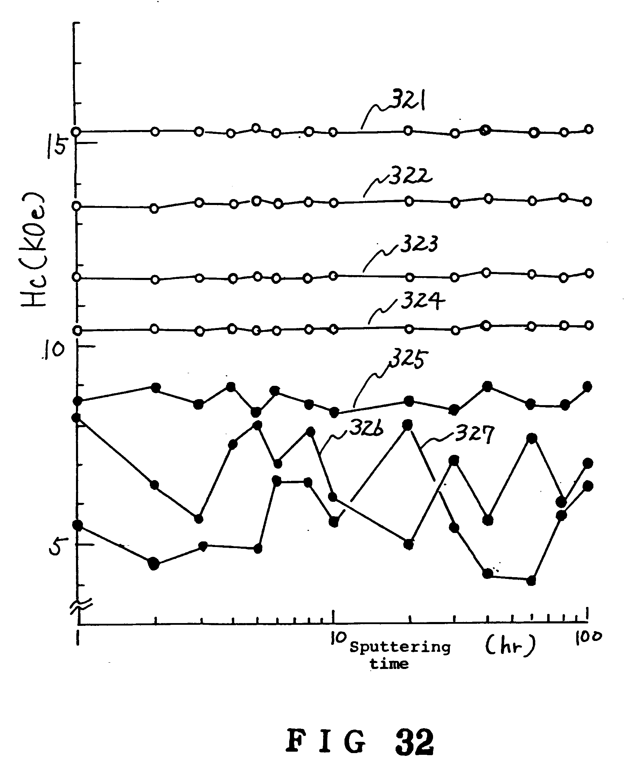

Targets obtained from foamed sheets having a pore diameter of not less than 10 µm were mounted on the sputtering device shown in Figure 2 for film formation. In the case of each of these targets, discharge was stable from the beginning and there was no problem. Each target was subjected to sputtering for a long time to examine the relationship between the sputtering time and the magnetic characteristic of the film. The results are shown in Figures 31 and 32.

In Figure 31, the reference numerals 311 to 317 denote targets obtained by using foamed sheets having pore diameters of 10 µm, 24 µm, 38 µm, 53 µm, 120 µm, 230 µm and 570 µm, respectively. It was confirmed that the films formed by using the targets obtained from the foamed sheets having pore diameters of 10 µm to 570 µm had a constant magnetic characteristic at any sputtering time and were adequately usable. It is because the difference in the porosity among the foamed sheets makes the compositions of the targets different that the magnetic characteristics of the films are different, and this has no direct relationship with the present invention.

In Figure 32, the reference numerals 321 to 327 denote targets obtained from foamed sheets having pore diameters of 730 µm, 1.0 mm, 1.5 mm, 2.5 mm, 3.0 mm, 3.2 mm and 4.0 mm, respectively. It was confirmed that films formed by using the targets obtained from foamed sheets having pore diameters of 730 µm to 2.5 mm had a constant magnetic characteristic at any sputtering time and were adequately usable. In the film formed by using the target 325 obtained from a foamed sheet having a pore diameter of 3.0 mm, the magnetic characteristic varies slightly depending on the sputtering time. This is because the large pore size causes a variation in the ratio of the RE, RE-TM and TM on the surface of the target depending upon the sputtering time. The target 325 obtained by using the foamed sheet having a pore diameter of about 3.0 mm is usable because the variation of the magnetic characteristic of the film obtained is not very large. However, in the targets 326 and 327 obtained by using foamed sheets having pore diameters of 3.2 mm and 4.0 mm respectively, the variation of the magnetic characteristics of the films obtained is so large that these targets 326 and 327 are not usable. Accordingly, the average pore diameter of a foamed TM sheet used for manufacturing a target of the present invention should be 10 µm to 3.0 mm.

It was confirmed that it is necessary to use a foamed TM sheet having a pore diameter of 10 µm to 3 mm in other compositions containing at least one heavy rare earth element selected from the group consisting of Gd, Tb and Dy and at least one transition metal selected from the group consisting of Fe and Co, such as DyFeCo, TbGdFeCo, TbFe, GdFeCo, GdDyFeCo, GdDyTbFeCo, DyTbFeCo, TbCo, GdTbFe and TbDyCo.

As described above, it has been found that the porosity and the particle diameter or the pore diameter of a powder or a foamed sheet are important and it is necessary to use a powder of a foamed sheet having a porosity and a particle diameter or a pore diameter in a specific range in the impregnation method of making a target according to the present invention. The composition of a master alloy ingot is also important. The composition of a master alloy is determined by the melting point and the metal structure of the master alloy, namely the ratio of the rare earth single phase and the alloy phase of a RE₁TM₂ (i.e. the alloy phase of an intermetalic compound comprising 1 part of RE and 2 parts of TM).

This will be explained in detail with reference to the following examples.

### Example 8-1

When NdDyFeCo targets were produced by the impregnation methods described above, a master alloy having a composition of 72.2 at% of (Nd_{0.2}Dy_{0.8}) and 27.8 at% of (Fe_{0.8}Co_{0.2}) was used, as described in Examples 3-1 and 4-4. This composition, in the vicinity of the eutectic, is closer to the rare earth (RE) metal side in the phase diagram and this alloy has a low melting point (about 830°C), so that it is suitable for the impregnation method. In this example, the chemical composition range of a master alloy which enables the manufacture of a target by the impregnation method was examined.

Various master alloys having different chemical compositions were prepared. Targets were manufactured by using each of the alloys and the same Fe-Co powder (having a porosity of 62.4%) as that used in Example 3-1 by the impregnation method. Table 11 shows the composition and the melting point of the master alloy used, and the finished state of the target manufactured by heating the material at the melting point of the alloy.

**Table 11**

| Composition of master alloy (at%) | Melting point (°C) | Finished state of target |
|---|---|---|
| (NdDy)₄₉(FeCo)₅₁ | 1220 | A part of FeCo powder melted. |
| (NdDy)₅₀(FeCo)₅₀ | 1200 | Impregnation in the state of complete powder |
| (NdDy)₅₅(FeCo)₄₅ | 1150 | Impregnation in the state of complete powder |
| (NdDy)₆₅(FeCo)₄₅ | 1150 | Impregnation in the state of complete powder |
| (NdDy)₆₅(FeCo)₃₅ | 980 | Impregnation in the state of complete powder |
| (NdDy)₇₂(FeCo)₂₈ | 850 | Impregnation in the state of complete powder |
| (NdDy)₇₈(FeCo)₂₂ | 1000 | Impregnation in the state of complete powder |
| (NdDy)₈₂(FeCo)₁₈ | 1100 | Impregnation in the state of complete powder |
| (NdDy)₉₀(FeCo)₁₀ | 1200 | Impregnation in the state of complete powder |
| (NdDy)₉₁(FeCo)₉ | 1230 | A part of FeCo powder melted. |

From Table 11, it is clear that when a master alloy having a melting point exceeding 1,200°C is used, a part of the Fe-Co powder begins to melt, thereby making the impregnation impossible. When master alloys having a melting point of not higher than 1,200°C were used, good targets were obtained by the imrpegnation method without melting the FeCo powder. Accordingly, it is necessary to use a master alloy having a melting point not higher than 1,200°C.

It was confirmed that it is necessary to use a master alloy having a melting point in the above-described range in other compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as PrTbFeCo, SmGdFeCo, SmGdTbFeCo, NdTbFeCo, NdGdFeCo, NdPrDyFeCo, NdPrDyTbFeCo, PrDyFeCo, NdSmGdTbFeCo, CeNdDyFeCo and CeNdPrDyFeCo.

### Example 8-2

TbFeCo targets were manufactured from various master alloys having different chemical compositions and the powder of an alloy of 90 at% of Fe and 10 at% of Co having a porosity of 43% was prepared by the impregnation method in the same way as in Example 3-5. Table 12 shows the chemical composition and the melting point of the master alloy used, and the finished state of the target manufactured by heating the material at the melting point of the alloy.

**Table 12**

| Composition of master alloy (at%) | Melting point (°C) | Finished state of target |
|---|---|---|
| Tb₃₉(FeCo)₆₁ | 1210 | A part of FeCo powder melted. |
| Tb₄₀(FeCo)₆₀ | 1200 | Impregnation in the state of complete powder |
| Tb₅₄(FeCo)₄₆ | 1100 | Impregnation in the state of complete powder |
| Tb₆₃(FeCo)₃₇ | 1000 | Impregnation in the state of complete powder |
| Tb₇₂(FeCo)₂₈ | 850 | Impregnation in the state of complete powder |
| Tb₇₈(FeCo)₂₂ | 1000 | Impregnation in the state of complete powder |
| Tb₈₃(FeCo)₁₇ | 1100 | Impregnation in the state of complete powder |
| Tb₈₉(FeCo)₁₁ | 1200 | Impregnation in the state of complete powder |
| Tb₉₀(FeCo)₁₂ | 1220 | A part of FeCo powder melted. |

From Table 12 it is clear that when a master alloy having a melting point exceeding 1,200°C is used, a part of the Fe-Co powder begins to melt, thereby making the impregnation impossible as in the case of NdDyFeCo. When master alloys having a melting point of not higher than 1,200°C were used, however, good targets were obtained by the impregnation method without melting the FeCo powder. Accordingly, it is necessary to use a master alloy having a melting point of higher than 1,200°C.

It was confirmed that it is also necessary to use a master alloy having a melting point in the above-described range in other compositions containing at least one heavy rare earth element selected from the group consisting of Gd, Tb and Dy and at least one transition metal selected from the group consisting of Fe and Co, such as DyFeCo, TdGdFeCo, TbFe, GdFeCo, GdDyFeCo, GdD TbFeCo, DyTbFeCo, TbCo, GdTbFe and TbDyCo.

The metal structures of the targets obtained are different depending upon the chemical compositions of the master alloys such as those used in Examples 8-1 and 8-2. In other words, the amounts of intermetallic compound phase produced in the RE₁-TM₂ are different. If a master alloy having a composition on the RE lean side, e.g. RE₄₀TM₆₀ is used, the intermetallic compound phase increases, while if a master alloy having a composition on the RE rich side, e.g. RE₈₉TM₁₁, is used, the intermetallic compound phase reduces. The optimum composition of a master alloy is selected in accordance with the sputtering device used or the film formation method.

In the case where the amount of intermetallic compound phase cannot be controlled only by the chemical composition of a master alloy, it may be controlled by heat treating again the target obtained at a temperature lower than the melting point.

### Example 9-1

NdDyFeCo targets manufactured by the impregnation method used in Example 3-1 were subjected to various heat treatments to examine the change in the amount of intermetallic compound phase of (NdDy)₁(FeCo)₂. The heat treatment conditions and the amount of intermetallic compound phase are shown in Table 13. Heat treatment was carried out in vacuo in the non-pressurized state.

**Table 13**

| Heat treating conditions | Amount of intermetallic compound phase (area%) |
|---|---|
| Untreated | 10 |
| 400°C 2 hr | 11 |
| 400°C 10 hr | 15 |
| 400°C 20 hr | 20 |
| 600°C 2 hr | 12 |
| 600°C 10 hr | 20 |
| 600°C 20 hr | 30 |
| 700°C 2 hr | 14 |
| 700°C 10 hr | 30 |
| 700°C 20 hr | 50 |
| 700°C 25 hr | 60 |

As shown in Table 13, it will be understood that the higher the temperature and the longer the time, the greater is the amount of intermetallic compound phase. Since the intermetallic compound phase is produced by the diffusion of the solid phase, it is natural that it depends on temperature and time.

The optimum amount of intermetallic compound phase is determined by the sputtering device and the sputtering method. Several examples will be cited below.

In the case of using a sputtering device such as that shown in Figure 2, if the substrate holder 22 is rotated and a substrate mounted thereon is rotated on its own axis (the substrate rotates both together with the substrate holder and on its own axis), the amount of intermetallic compound phase does not matter. On the other hand, if the substrate is not rotated on its own axis (e.g. the substrate is rotated only together with the substrate holder), the amount of intermetallic compound is preferably about 10 to 30 area %. The optimum amount is determined by the distance between the centre of the substrate, the distance between the centre of the target and the substrate holder, and the sputtering conditions (Argon pressure, power).

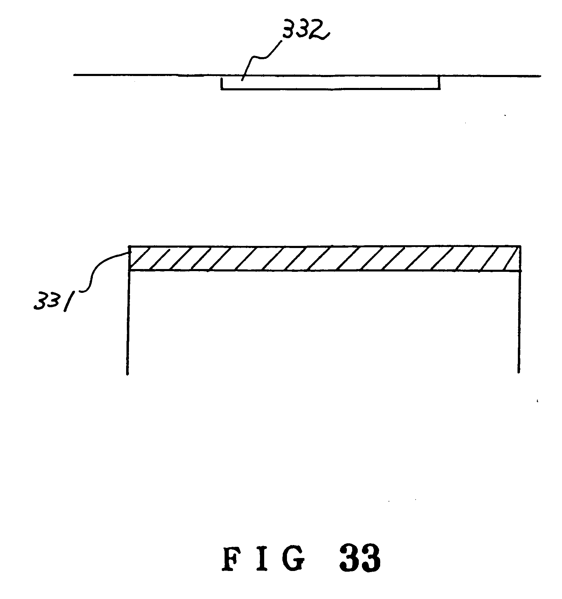

In the case of using a sputtering device such as that shown in Figure 33, a target 331 is disposed opposite to a substrate 332 which does not move. In this case, the amount of intermetallic compound is preferably about 15 to 40 area %. The optimum amount is determined by the distance between the target and the substrate, and the sputtering conditions (Argon pressure, power).

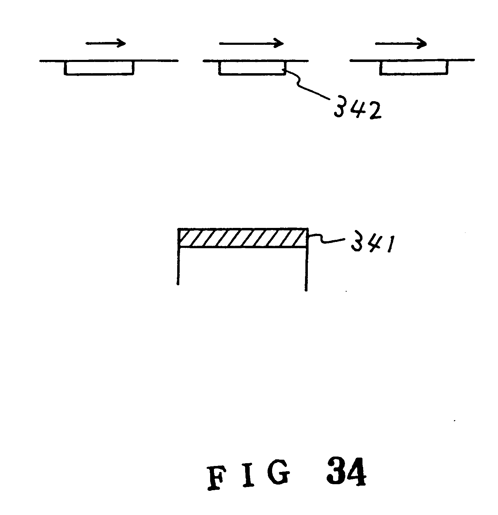

In the case of using a sputtering device such as that shown in Figure 34 in which a substrate 342 passes over a target 341, the amount of intermetallic compound is preferably about 20 to 60 area %. The optimum amount is determined by the distance between the target and the substrate, and the sputtering conditions (Argon pressure, power).

Similar results to those of Example 9-1 were obtained in other compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as PrTbFeCo, SmGdFeCo, SmGdTbFeCo, NdTbFeCo, NdGdFeCo, NdPrDyFeCo, NdPrDyTbFeCo, PrDyFeCo, NdSmGdTbFeCo, CeNdDyFeCo and CeNdPrDyFeCo.

### Example 9-2

The TbFeCo targets manufactured by the impregnation method described in Example 3-5 were subjected to various heat treatments to examine the change in the amount of intermetallic compound phase of Tb₁(FeCo)₂. The heat treatment conditions and the amount of intermetallic compound phase are shown in Table 14. Heat treatment was carried out in vacuo in the non-pressurized state.

**Table 14**

| Heat treating conditions | Amount of intermetallic compound phase (at%) |
|---|---|
| Untreated | 7 |
| 400°C 3 hr | 8 |
| 400°C 15 hr | 12 |
| 400°C 30 hr | 17 |
| 400°C 60 hr | 27 |
| 650°C 3 hr | 10 |
| 650°C 15 hr | 22 |
| 650°C 30 hr | 37 |
| 750°C 2 hr | 11 |
| 750°C 15 hr | 37 |
| 750°C 30 hr | 67 |

As shown in Table 14, it will be understood that the higher the temperature and the longer the time, the greater is the amount of intermetallic compound phase, as in Example 9-1.

The optimum amount of intermetallic compound phase is determined by the sputtering device and the sputtering method.

Similar results to those of Example 9-2 were obtained in the case of other compositions containing at least one heavy rare earth element selected from the group consisting of Gd, Tb and Dy and at least one transition metal selected from the group consisting of Fe and Co, such as DyFeCo, TbGdFeCO, TbFe, GdFeCo, GdDyFeCo, GdDyTbFeCo, DyTbFeCo, TbCo, GdTbFe and TbDyCo.

In the impregnation method described above in which a master alloy is placed on a metal powder or a foamed metal sheet, it is necessary to control the porosity of the powder or the foamed sheet in order to control the composition. A method of using a pwoder and controlling the composition of the target without controlling the porosity of the powder will now be described.

To state this method briefly, a powder of a transition metal and a powder obtained by pulverizing a master alloy of a rare earth metal and a transition metal having a composition in the vicinity of the eutectic are mixed in an appropriate ratio and thoroughly mixed so as to be uniform. Thereafter the mixed powder is charged into a mould, heated to about 1,000°C is the non-pressurized state and cooled. The moulded body is then machined to obtain a target.

### Example 10-1

An NdDyFeCo target was manufactured. An ingot of a master alloy of 72.2 at% of (Nd_{0.2}Dy_{0.8}) and 27.8 at% of (Fe_{0.8}Co_{0.2}) was first prepared as a raw material. The ingot was ground by a jaw crusher and then pulverized by a ball mill or the like into a powder having an average particle diameter of 200 µm. A powder of an alloy of 80 at% of Fe and 20 at% of Co having a particle diameter of 200 µm was next prepared and thoroughly mixed with the powder of the master alloy so that the atomic ratio of Nd, Dy, Fe and Co as a whole was 5.5 : 22.0 : 58.0:14.0. The mixed powder was charged into a crucible of 4" φ in inner diameter, which was evacuated and heated to about 1,050°C in the non-pressurized state. At this time the powder of the master alloy was molten but the FeCo powder was not melted. The molten master alloy therefore surrounded the FeCo powder and both were cooled in this state. The molten master alloy separated into two phases of NdDy and (NdDy)₁(FeCo)₂, Thus a target with the three phases mixed on the surface thereof was obtained.

According to this method, it is easy to control the chemical composition of the finished target, because it is determined by the volume ratio of the powder of the master alloy and of the FeCo powder which are initially mixed, and the control of the porosity of the powder is dispensed with.

The thus-obtained target was mounted on a sputtering device such as that shown in Figure 2 for film formation, and the magnetic characteristic and the composition distribution of the film obtained were evaluated. The RE content was uniformly 28 to 28.5 at% and the Hc was uniformly 9.7 to 10.5 KOe. The amount of oxygen was as small as 490 ppm. When the target was used again after 24 hour standing in the air, the sputtering discharge was stable from the beginning and the magnetic characteristic of the film was also stable from the beginning.

Although a powder is used in the manufacturing method of this embodiment, since it is not a sintering method and the powder of the master alloy is completely molten, the packing density is as large as 99.3%, so that even if the target is left to stand in the air, the surface oxidation never proceeds to the interior.

It was confirmed that this manufacturing method is usable with the same effect in the case of other compositions containing at least one light rare earth metal selected from the group consisting of Sm, Nd, Pr and Ce, at least one heavy rare earth element selected from the group consisting of Gd, Tb and Dy and at least one transition metal selected from the group consisting of Fe and Co, such as PrTbFeCo, SmGdFeCo, SmGdTbFeCo, NdTbFeCo, NdGdFeCo, NdprDyFeCo, NdPrDyTbFeCo, PrDyFeCO, NdSmGdTbFeCo, CeNdDyFeCo and CeNdPrDyFeCo.

### Example 10-2

A TbFeCo target was manufactured. An ingot of a master alloy of 72 at% of Tb and 26.2 at% of Fe and 1.8 at% of Co was first prepared as a raw material. The ingot was ground by a jaw crusher and then pulverized by a ball mill or the like into a powder having an average particle diameter of 200 µm. A powder of an alloy of 93.6 at% of Fe and 6.4 at% of Co having a particle diameter of 200 µm was next prepared and thoroughly mixed with the powder of the master alloy so that the atomic ratio of Tb, Fe and CO as a whole was 22 : 73 : 5. The mixed powder was charged into an alumina mould of 4" φ in inner diameter, which was evacuated, heated to about 1,050°C in the non-pressurized state and thereafter cooled. The moulded body was machined to obtain a sputtering target. This target consists of three phases of Tb, Tb₁(FeCo)₂, and FeCo.

The thus-obtained target was mounted on a sputtering device such as that shown in Figure 2 for film formation, and the magnetic characteristic of the film and the composition distribution on the substrate holder were evaluated. The RE content was uniformly 21.5 to 22.0 at% and the Hc was uniformly 14.5 to 15.2 KOe. The amount of oxygen was as small as 440 ppm and the packing density was as large as 99.5%. When the target was used again after standing in the air for 24 hours, the sputtering discharge was stable from the beginning and the magnetic characteristic of the film was also stable from the beginning.

It was confirmed that this manufacturing method can also be used with the same effect on other compositions containing at least one heavy rare earth element selected from the group consisting of Gd, Tb and Dy and at least one transition metal selected from the group consisting of Fe and Co, such as DyFeCo, TbGdFeCo, TbFe, GdFeCo, GdDyFeCo, GdDyTbFeCo, DyTbFeCo, TbCo, GdTbFe and TbDyCo.

It goes without saying that the melting point of the master alloy must be not higher than 1,200°C in the method of this embodiment (Examples 10-1 and 10-2) as in Examples 8-1 and 8-2.

Although the powders or the foamed sheets of a transition metal used in the methods of Examples 1-1 to 10-2 are based on an FeCo alloy, it was confirmed that it is possible to manufacture a target of the present invention and the target obtained has similar effects by using Fe as the powder or foamed sheet of a transition metal and RE-FeCo or RE-Co as the master alloy.

It was also confirmed that it is possible to manufacture a target of the present invention and the target obtained has similar effects by using FeCo or Co as the powder or foamed sheet of a transition metal and RF-Fe as the master alloy. The use of a mixed powder of Fe and Co naturally enabled the manufacture of a target of the present invention.

It was also confirmed that the manufacture of a target by a method as described above is possible and the target obtained has similar effects even if additives such as Ti, Cr, Aℓ, Zr, Pt, Au, Ag and Cu or inevitable impurities such as Si, Ca and C are mixed with the raw materials.

As described above, a sputtering target obtained by a method as described and mounted in various sputtering devices enables sputtering having a uniform chemical composition distribution in the film forming plane, has a small amount of oxygen and a high packing density, and produces stable sputtering from the beginning. In addition, when the target is used again after it has been left to stand in the air, sputtering is stable from the beginning and the magnetic characteristic of the film is also stable from the beginning.

## Claims

1. A method of forming a sputtering target for use in producing a magneto-optic recording medium of a rare earth-transition metal alloy by sputtering, the method including the step of charging a powdered transition metal or a powdered alloy of a plurality of transition metals into a container, the method being characterised by charging in addition a master alloy of one or more rare earth metals and of one or more transition metals into the container; heating the container to a temperature between the melting point of the transition metal or transition metal alloy and the melting point of the master alloy; and cooling the resulting material and forming it into the sputtering target.

2. A method of forming a sputtering target for use in producing a magneto-optic recording medium of a rare earth-transition metal alloy by sputtering, the method including the step of charging a foamed transition metal or a foamed alloy of a plurality of transition metals into a container, the method being characterised by charging in addition a master alloy of one or more rare earth metals and of one or more transition metals into the container; heating the container to a temperature between the melting point of the transition metal or transition metal alloy and the melting point of the master alloy; and cooling the resulting material and forming it into the sputtering target.

3. A method as claimed in claim 1 or 2 characterised in that the master alloy is formed by melting together at least one rare earth metal and at least one transition metal in the container.

4. A method as claimed in claim 1 or 2 characterised in that the master alloy is charged into the container in powder form.

5. A method as claimed in claim 1 or 2 characterised in that the master alloy is charged into the container in ingot form.

6. A method as claimed in claim 1 or in any claim appendent thereto characterised in that the powder of the transition metal or transition metal alloy has a porosity of between 30% and 80%.

7. A method as claimed in claim 1 or in any claim appendant thereto characterised in that the powder of the transition metal or transition metal alloy has an average particle diameter of between 10 µm and 3.0 mm.

8. A method as claimed in claim 2 or in any claim appendant thereto, characterised in that the foamed transition metal or foamed transition metal alloy has a porosity of between 30% and 80%.

9. A method as claimed in claim 2 or in any claim appendant thereto, characterised in that the foamed transition metal or foamed transition metal alloy has an average pore diameter of between 10 µm to 3.0 mm.

10. A method as claimed in any preceding claim characterised in that the container is charged in addition with at least one rare earth metal and at least one transition metal in powdered form.

11. A method as claimed in any preceding claim characterised in that the container is a crucible, the cooled material therein being molten and being cast into a mould, and the moulded product being machined to form the target.

12. A method as claimed in claim 11 characterised in that the material in the mould is subjected to heat treatment.

13. A method as claimed in any preceding claim characterised in that the melting point of the master alloy does not exceed 1200°C.

14. A method as claimed in any preceding claim, characterised in that the constituents of the target include at least one light rare earth metal selected from the group comprising Sm, Nd, Pr and Ce.

15. A method as claimed in any preceding claim, characterised in that the constituents of the target include at least one heavy rare earth metal selected from the group comprising Gd, Tb and Dy.

16. A method as claimed in any preceding claim, characterised in that the constituents of the target include at least one transition metal selected from the group comprising Fe and Co.

## Patentansprüche

1. Verfahren zum Bilden einer Sputterquelle zur Verwendung bei der Herstellung eines magneto-optischen Aufzeichnungsmediums aus einer Seltenerdmetall-Übergangsmetall-Legierung durch Sputtern, das den schritt aufweist des Füllens eines Übergangsmetall-Pulvers oder eines Pulvers einer Legierung aus einer Mehrzahl von Übergangsmetallen in einen Behälter,
**gekennzeichnet durch**
zusätzliches Füllen einer Vorlegierung aus einem oder mehreren Seltenerdmetallen und aus einem oder mehreren Übergangsmetallen in den Behälter;
Erhitzen des Behälters auf eine Temperatur zwischen dem Schmelzpunkt des Übergangsmetalls oder der Übergangsmetall-Legierung und dem Schmelzpunkt der Vorlegierung; und
Abkühlen des sich ergebenden Materials und Formen des Materials zu der Sputterquelle.

2. Verfahren zum Bilden einer Sputterquelle zur Verwendung bei der Herstellung eines magneto-optischen Aufzeichnungsmediums aus einer Seltenerdmetall-Übergangsmetall-Legierung durch Sputtern, das den Schritt aufweist des Füllens eines porösen Übergangsmetalls oder einer porösen Legierung aus einer Mehrzahl von Übergangsmetallen in einen Behälter,
**gekennzeichnet durch**
zusätzliches Füllen einer Vorlegierung aus einem oder mehreren Seltenerdmetallen und aus einem oder mehreren Übergangsmetallen in den Behälter;
Erhitzen des Behälters auf eine Temperatur zwischen dem Schmelzpunkt des Übergangsmetalls oder der Übergangsmetall-Legierung und dem Schmelzpunkt der Vorlegierung; und
Abkühlen des sich ergebenden Materials und Formen des Materials zu der Sputterquelle.

3. Verfahren nach Anspruch 1 oder 2,
**dadurch gekennzeichnet**,
daß die Vorlegierung gebildet wird durch Zusammenschmelzen von mindestens einem Seltenerdmetall und mindestens einem Übergangsmetall in dem Behälter.

4. Verfahren nach Anspruch 1 oder 2,
**dadurch gekennzeichnet,**
daß die Vorlegierung in Pulverform in den Behälter gefüllt wird.

5. Verfahren nach Anspruch 1 oder 2,
**dadurch gekennzeichnet,**
daß die Vorlegierung in Gußstückform in den Behälter gefüllt wird.

6. Verfahren nach Anspruch 1 oder einem von ihm abhängigen Anspruch,
**dadurch gekennzeichnet,**
daß das Pulver des Übergangsmetalls oder der Übergangsmetall-Legierung eine Porosität von zwischen 30 % und 80 % hat.

7. Verfahren nach Anspruch 1 oder einem von ihm abhängigen Anspruch,
**dadurch gekennzeichnet,**
daß das Pulver des Übergangsmetalls oder der Übergangsmetall-Legierung einen mittleren Teilchendurchmesser von zwischen 10 µm und 3,0 mm hat.

8. Verfahren nach Anspruch 2 oder einem von ihm abhängigen Anspruch,
**dadurch gekennzeichnet,**
daß das poröse Übergangsmetall oder die poröse Übergangsmetall-Legierung eine Porosität von zwischen 30 % und 80 % hat.

9. Verfahren nach Anspruch 2 oder einem von ihm abhängigen Anspruch,
**dadurch gekennzeichnet,**
daß das poröse Übergangsmetall oder die poröse Übergangsmetall-Legierung einem mittleren Porendurchmesser von zwischen 10 µm bis 3,0 mm hat.

10. Verfahren nach einem der vorhergehenden Ansprüche,
**dadurch gekennzeichnet,**
daß der Behälter zusätzlich mit mindestens einem Seltenerdmetall und mindestens einem Übergangsmetall in Pulverform befüllt wird.

11. Verfahren nach einem der vorhergehenden Ansprüche,
**dadurch gekennzeichnet,**
daß der Behälter ein Tiegel ist, das abgekühlte Material darin geschmolzen und in eine Form gegossen wird, und das geformte Produkt zur Bildung der Quelle bearbeitet wird.

12. Verfahren nach Anspruch 11,
**dadurch gekennzeichnet,**
daß das Material in der Form einer Wärmebehandlung unterworfen wird.

13. Verfahren nach einem der vorhergehenden Ansprüche,
**dadurch gekennzeichnet,**
daß der Schmelzpunkt der Vorlegierung 1200°C nicht überschreitet.

14. Verfahren nach irgendeinem vorhergehenden Anspruch,
**dadurch gekennzeichnet,**
daß zu den Bestandteilen der Quelle mindestens ein leichtes Seltenerdmetall gehört, das ausgewählt ist aus der Sm, Nd, Pr und Ce aufweisenden Gruppe.

15. Verfahren nach irgendeinem vorangehenden Anspruch,
**dadurch gekennzeichnet,**
daß zu den Bestandteilen der Quelle mindestens ein schweres Seltenerdmetall gehört, das ausgewählt ist aus der Gd, Tb, und Dy aufweisenden Gruppe.

16. Verfahren nach irgendeinem vorangehenden Anspruch,
**dadurch gekennzeichnet,**
daß zu den Bestandteilen der Quelle mindestens ein Übergangsmetall gehört, das ausgewählt ist aus der Fe und Co aufweisenden Gruppe.

## Revendications

1. Un procédé pour former une cible de pulvérisation cathodique destinée à être utilisée dans la fabrication d'un support d'enregistrement magnéto-optique constitué d'un alliage de terre rare et de métal (métaux) de transition par pulvérisation cathodique, le procédé comprenant l'étape consistant à charger un métal de transition pulvérulent ou un alliage pulvérulent d'une pluralité de métaux de transition dans un récipient, le procédé étant caractérisé par les étapes consistant à charger en outre un alliage maître composé de un ou de plusieurs métaux de terre rare et d'un ou de plusieurs métaux de transition dans le récipient; à chauffer le récipient à une température située entre le point de fusion du métal de transition ou de l'alliage métallique de transition et le point de fusion de l'alliage maître; et à refroidir le matériau résultant et à le former dans la cible de pulvérisation cathodique.

2. Un procédé pour former d'une cible de pulvérisation cathodique destinée à être utilisée dans la fabrication d'un support d'enregistrement magnéto-optique d'un alliage de terre rare et de métal (métaux) de transition, par pulvérisation cathodique, le procédé comportant l'étape consistant à charger un métal de transition expansé ou alvéolaire ou bien un alliage expansé ou alvéolaire d'une pluralité de métaux de transition dans un récipient, le procédé étant caractérisé par les étapes consistant à charger en outre un alliage maître composé d'un ou de plusieurs métaux de terre rare et d'un ou de plusieurs métaux de transition dans le récipient; à chauffer le récipient à une température située entre le point de fusion du métal de transition ou de l'alliage métallique de transition et le point de fusion de l'alliage maître; et à refroidir le matériau résultant et à le former dans la cible de pulvérisation cathodique.

3. Un procédé selon la revendication 1 ou 2, caractérisé en ce que l'alliage maître est réalisé par la cofusion d'au moins un métal de terre rare et d'au moins un métal de transition dans le récipient.

4. Un procédé selon la revendication 1 ou 2, caractérisé en ce que l'alliage maître est chargé dans le récipient sous forme de poudre.

5. Un procédé selon la revendication 1 ou 2, caractérisé en ce que l'alliage maître est chargé dans le récipient sous forme de lingot.

6. Un procédé selon la revendication 1 ou l'une quelconque des revendications qui en dépend, caractérisé en ce que la poudre du métal de transition ou de l'alliage de métal (métaux) de transition présente à une porosité comprise entre 30% et 80%.

7. Un procédé selon la revendication 1 ou l'une quelconque des revendication qui en dépende, caractérisé en ce que la poudre du métal de transition ou de l'alliage de métal (métaux) de transition présente un diamètre particulaire moyen compris entre 10 µm et 3,0 mm.

8. Un procédé selon la revendication 1 ou de l'une quelconque des revendications qui en dépend, caractérisé en ce que le métal de transition expansé ou l'alliage de métal (métaux) de transition expansé présente une porosité comprise entre 30% et 80%.

9. Un procédé selon la revendication 2 ou l'une quelconque des revendication qui en dépend, caractérisé en ce que le métal de transition expansé ou l'alliage de métal (métaux) de transition expansé présente un diamètre moyen des pores compris entre 10 µm et 3,0 mm.

10. Un procédé selon l'une quelconque des revendications précédentes caractérisé en ce qu'on charge en outre le récipient avec au moins un métal de terre rare et au moins un métal de transition, sous forme pulvérulente.

11. Un procédé selon l'un quelconque des revendications précédentes caractérisé en ce que le récipient est un creuset, le matériau refroidi qu'il contient étant fondu et étant coulé dans un moule, et le produit moulé étant usiné afin de former la cible.

12. Un procédé selon la revendication 11, caractérisé en ce qu'on soumet le matériau dans le moule à un traitement thermique.

13. Un procédé selon l'une quelconque des revendications précédentes, caractérisé en ce que le point de fusion de l'alliage maître ne dépasse pas 1 200°C.

14. Un procédé selon l'une quelconque des revendications précédentes, caractérisé en ce que les constituants de la cible comprennent au moins un métal léger de terre rare choisi dans le groupe comprenant Sm, Nd, Pr et Ce.

15. Un procédé selon l'une quelconque des revendications précédentes, caractérisé en ce que les constituants de la cible comprennent au moins un métal lourd de terre rare choisi dans le groupe comprenant Gd, Tb, Dy.

16. Un procédé selon l'une quelconque des revendications précédentes, caractérisé en ce que les constituants de la cible comprennent au moins un métal de transition choisi dans le groupe comprenant Fe et Co.
